# EUROPÄISCHE PATENTSCHRIFT

(11) **EP 2 269 238 B1**
(45) Veröffentlichungstag und Bekanntmachung des Hinweises auf die Patenterteilung: **05.08.2020**
(21) Anmeldenummer: 09737882.2
(22) Anmeldetag: 29.04.2009
(51) Int. Cl.: H01L 33/48, H01L 33/64

(54) **GEHÄUSE FÜR LEDS MIT HOHER LEISTUNG UND VERFAHREN ZU DESSEN HERSTELLUNG**
HOUSING FOR HIGH-POWER LEDS AND FABRICATION METHOD THEREOF
BOÎTIER POUR DEL DE FORTE PUISSANCE ET SON PROCEDE DE FABRICATION

(30) Priorität: 29.04.2008 DE 102008021435
(43) Veröffentlichungstag der Anmeldung: 05.01.2011
(73) Patentinhaber: Schott AG, 55122 Mainz (DE)
(72) Erfinder: RINDT, Matthias, 63486 Bruchköbel (DE); KIERMEIER, Josef, 84051 Essenbach (DE); ZETTERER, Thomas, 84034 Landshut (DE); HETTLER, Robert, 84036 Kumhausen (DE); KAMARI, Shaifullah Bin Mohamed, 440027 Singapore (SG); CHEW, Lea-Li, 7030711 Singapore (SG); BHOSALE, Rohit, 329111 Singapore (SG)
(74) Vertreter: Herden, Andreas F.
(86) Internationale Anmeldenummer: PCT/EP2009/003109
(87) Internationale Veröffentlichungsnummer: WO 2009/132838

(56) Entgegenhaltungen:
- EP-A2- 0 114 917
- CN-A- 1 953 218
- DE-A1- 10 118 630
- DE-A1-102004 014 207
- DE-A1-102004 034 166
- DE-U1-202007 003 496
- GB-A- 2 413 698
- US-A1- 2005 280 019
- US-A1- 2007 201 213
- Anonymous: "Glass-to-metal seal - Wikipedia, the free encyclopedia", , 5 February 2008 (2008-02-05), XP055563581, Retrieved from the Internet: URL:https://web.archive.org/web/2008020502 0410/en.wikipedia.org/wiki/Glass-to-metal_ seal [retrieved on 2019-03-01]

## Beschreibung

### Beschreibung der Erfindung

Die vorliegende Erfindung betrifft ein Gehäuse für optoelektronische Bauteile, wie LEDs, und ein Verfahren zur Herstellung des genannten Gehäuses.

### Hintergrund der Erfindung

Derzeit werden sogenannte "High Power Light Emitting Diodes" (LED) in Harz- bzw. Kunststoffkonstruktionen verkapselt. Ein solches Package oder Gehäuse ist beispielsweise in der WO 2004-053933 A2 beschrieben. Ein solcher Harz beinhaltet organische Materialien. Diese können aufgrund von Vorgängen, wie Ausgasen und/oder Vergilben, zu einer Reduzierung der Lebenszeit einer LED führen. Zudem ist eine LED in einem solchen Gehäuse nicht hermetisch verkapselt. Demzufolge können Umwelteinflüsse zu einer Degradation von Materialien, Oberflächen und elektrischen Verbindungen führen. Ferner stellt die thermische Stabilität des Harzes für Vorrichtungen mit einem höheren Output, z. B. 5 W-LEDs, ein Problem dar.

Im Dokument DE 10 2004 014 207 A1 ist eine Metall-Keramik-Verbindung für einen mehrteiligen Gehäusekörper für ein optoelektronisches Bauteil beschrieben.

Im Dokument DE 20 2007 003 496 U1 ist eine elektronische Einrichtung mit Wärmeabfuhr gezeigt. Ein Metallsubstrat mit hoher Wärmeleitfähigkeit wird bearbeitet durch einen elektrolytischen Oxidationsprozess, um eine oxidierte Isolationsschicht zu erhalten. Danach wird eine metallische leitende Schicht, zum Beispiel durch Elektroplattieren, auf die oxidierte Isolationsschicht aufgebracht.

Im Dokument US 2007/0201213 A1 ist ein LED-Gehäuse gezeigt. Bei einer Platine wird eine isolierende Oxidationsschicht durch anodische Oxidation erzeugt. Die metallische Platine wird mit einer strukturierten Oxidationsschicht bedeckt. Auf der Oxidationsschicht werden leitfähige Strukturen durch Plattieren gebildet.

In dem Dokument US 2005/0280019 A1 ist eine Metall-Hartlot-Keramik-Verbindung für ein LED-Gehäuse beschrieben.

DE 10 2004 034 166 A1 offenbart ein Gehäuse gemäß dem Oberbegriff des Anspruchs 1.

EP 0 114 917 A2 offenbart ein Gehäuse für ein Hochleistungshalbleiterbauelement, welches ein Kopfteil, ein Basisteil und einen Leiterrahmen, jeweils aus Metall, aufweist, bei dem Kopfteil, Basisteil und Leiterrahmen mittels einer Glasschicht miteinander verbunden sind und bei dem die Metallteile voroxidiert sind.

### Allgemeine Beschreibung der Erfindung

Vor diesem Hintergrund hat sich die vorliegende Erfindung daher zur Aufgabe gestellt, ein Gehäuse für optoelektronische Bauelemente, insbesondere für LEDs mit einer hohen Leistung, und ein Verfahren zur Herstellung eines solchen Gehäuses bereitzustellen, welche die vorstehend beschriebenen Nachteile des Standes der Technik zumindest vermindern.

Hierbei soll es insbesondere möglich sein, ein Gehäuse bereitzustellen, welches hermetische Eigenschaften besitzen kann. Zudem soll das Gehäuse kostengünstig herzustellen sein.

Gelöst werden diese Aufgaben durch das Gehäuse und das Verfahren gemäß der unabhängigen Ansprüche. Vorteilhafte Ausführungsformen sind Gegenstand der jeweiligen Unteransprüche.

Im Rahmen der Erfindung liegt ein Gehäuse für ein optoelektronisches Funktionselement, insbesondere eine LED, umfassend
- einen Verbund zumindest oder bestehend aus einem Basisteil und einem Kopfteil, welche zumindest mittels einer ersten Glasschicht, welche zwischen der Oberseite des Basisteils und der Unterseite des Kopfteils angeordnet ist, verbunden sind und
- und ein Abschnitt der Oberseite des Basisteils einen Montagebereich für zumindest ein opto-elektronisches Funktionselement definiert, so dass das Basisteil ein Kühlkörper für das opto-elektronische Funktionselement ist und
- das Kopfteil sich vorzugsweise zumindest abschnittsweise oder vollständig über den Umfang des Montagebereichs erstreckt und über dem Montagebereich einen Durchgangsbereich für die von dem opto-elektronischen Funktionselement emittierte und/oder zu empfangende Strahlung bildet,
- insbesondere wobei das Kopfteil ein Metall umfasst und/oder das Basisteil ein Metall umfasst und die Oberseite des Basisteils voroxidiert ist und/oder die Unterseite des Kopfteils voroxidiert ist.

Weiterhin erstreckt sich die Erfindung auf ein Verfahren zur Herstellung eines opto-elektronischen Funktionselementgehäuses, insbesondere für eine LED, umfassend
- Bereitstellen wenigstens eines Basisteils, dessen Oberseite vorzugsweise zumindest abschnittsweise einen Montagebereich für zumindest ein opto-elektronisches Funktionselement definiert, so dass das Basisteil einen Kühlkörper für das opto-elektronische Funktionselement bildet,
- Bereitstellen wenigstens eines Kopfteils, das sich vorzugsweise zumindest abschnittsweise oder vollständig über den Umfang des Montagebereichs erstreckt und über dem Montagebereich einen Durchgangsbereich für die von dem opto-elektronischen Funktionselement emittierte und/oder zu empfangende Strahlung bildet,
- insbesondere wobei das Basisteil in einer Matrix mit einer Vielzahl an Basisteilen (1) und/oder das Kopfteil in einer Matrix mit einer Vielzahl an Kopfteilen bereitgestellt wird bzw. werden,
- Bereitstellen oder Anordnen wenigstens einer ersten Glasschicht zwischen der Oberseite des Basisteils und Unterseite des Kopfteils und
- Zusammenfügen des Basisteils, der ersten Glasschicht und des Kopfteils und
- Erwärmen der ersten Glasschicht insoweit, dass das Glas eine Viskosität erreicht, bei der das Glas anhaftet und das Basisteil und das Kopfteil zumindest mittels der ersten Glasschicht einen Verbund bilden,
   insbesondere so dass eine Vielzahl an Gehäusen gleichzeitig hergestellt werden,
   insbesondere wobei die Gehäuse über das Basisteil und/oder das Kopfteil mittels Verbindungsstege an der Matrix mit der Vielzahl an Basisteilen und/oder an der Matrix mit der Vielzahl an Kopfteilen befestigt sind.

In einer Ausgestaltung werden das Basisteil, das Kopfteil und/oder das später erwähnte Anschlussteil jeweils in einer Matrix bereitgestellt. Das erfindungsgemäße Gehäuse ist insbesondere herstellbar oder hergestellt mit dem erfindungsgemäßen Verfahren. Das erfindungsgemäße Verfahren ist vorzugsweise ausgebildet zur Herstellung des erfindungsgemäßen Gehäuses.

Das Kopfteil bedeckt abschnittsweise das Basisteil. Es muss aber nicht zwangsläufig den Abschluss des Gehäuse zu seiner Oberseite hin bilden. Es bildet, insbesondere zumindest, einen Abschnitt einer Gehäusewand oder die Gehäusewand. Das Kopfteil kann daher auch als Gehäusewand oder Rahmen bezeichnet werden. Das Kopfteil umgibt den Montagebereich, insbesondere zumindest, abschnittsweise oder vollständig. Das zu montierende Funktionselement ist dann innerhalb des Kopfteils angeordnet. Es stellt auch eine Art Abdeckung für das Basisteil dar. In einer Ausführungsform bildet oder besitzt das Kopfteil zumindest einen, insbesondere elektrischen, Anschlussbereich für das Funktionselement. Dieser Bereich beschreibt einen Abschnitt des Kopfteils, an welchem zum Beispiel ein Draht oder eine Leiterbahn befestigt werden kann. Über den Anschlussbereich kann eine Verbindung des Innenraums des Gehäuses oder des Funktionselement mit der Umgebung hergestellt werden. Sofern das Kopfteil elektrisch leitfähig ist, kann der Anschlussbereich durch den Körper des Kopfteils an sich bereitgestellt werden. Somit ist das Kopfteil in einer Ausführungsform auch eine Art Leiterrahmen für das zu montierende Funktionselement, das vorzugsweise innerhalb des Kopfteils angeordnet wird. Um den Anschlussbereich bereitzustellen, kann ein Vorsprung oder ein Lötansatz, eine sogenannte Lötfahne, an der Außenseite des Kopfteils ausgebildet oder befestigt sein.

In einer Ausführungsform umfasst das Kopfteil ein oder besteht das Kopfteil aus einem Material, welches eine Temperaturbeständigkeit von mindestens 400 °C besitzt. Vorzugsweise umfasst das Kopfteil wenigstens ein anorganisches Material oder besteht das Kopfteil aus wenigstens einem anorganischen Material. In einer Version ist das Kopfteil somit ein anorganisches oder im Wesentlichen anorganisches Kopfteil. In einer Ausführungsform umfasst oder ist das Kopfteil eine Keramik und/oder ein Metall. In einer Ausführungsform ist das Metall ein Metall an sich oder eine Legierung. Das Metall ist hierbei zumindest ein Mitglied ausgewählt aus der Gruppe von Kupfer, Aluminium, Nickel, Eisen, vorzugsweise ferritischen Stahl oder Edelstahl und vorzugsweise austenitischen Stahl oder Edelstahl. Das Kopfteil unterstützt, bei entsprechender Wahl der Materialien, auch die Wärmeabfuhr.

Da das Kopfteil im Allgemeinen nicht im direkten Kontakt mit dem Montagebereich und dem zu montierenden Funktionslement steht bzw. kommt, weist das Kopfteil in einer Ausgestaltung an der Innenseite wenigstens einen Funktionselementanschlussbereich auf. Der Funktionselementanschlussbereich erstreckt sich, insbesondere zumindest, abschnittsweise über den Umfang des Montagebereichs. In einer Ausgestaltung ist der Funktionselementanschlussbereich als ein Sockel oder ein Piedestal ausgebildet. Dieser ist vorzugsweise seitlich an der Unterseite des Kopfteils positioniert oder ausgebildet und ragt in den genannten Durchgangsbereich.

Der Durchgangsbereich definiert einen Bereich, über welchen Licht oder Strahlung passieren und somit ein- und/oder austreten kann. Der Durchgangsbereich kann somit auch als Passage bezeichnet werden. Vorzugsweise ist der Durchgangsbereich als Öffnung in dem Kopfteil ausgebildet. Um zum Beispiel eine verbesserte Abstrahlung einer LED zu gewährleisten, ist der Querschnitt des Durchgangsbereichs von der Unterseite des Kopfteils zu seiner Oberseite hin, vorzugsweise kontinuierlich, vergrößert. In einer Ausführung besitzt der Durchgangsbereich im wesentlichen zumindest abschnittsweise die Gestalt eine Kegelstumpfs oder eines Pyramidenstumpfs. Nach dem Einbau des Funktionselements kann in dem Durchgangsbereich bzw. oberhalb des Durchgangsbereiches zum Beispiel, vorzugsweise als Deckel, ein optisches Bauteil, wie eine Linse, angeordnet werden. Vorzugsweise wird das optische Bauteil derart befestigt, dass der Innenraum hermetisch abgeschlossen ist.

In einer Ausführung kann auch ein sogenanntes Optik-Konverter-System in oder über dem Durchgangsbereich angeordnet werden. Vorzugsweise ist das Optik-Konverter-System ein Optik-Konverter-System, welches in der Patentanmeldung mit dem Namen *"Optik-Konverter-System für (W)LEDs"* beschrieben ist. Die genannte Patentanmeldung wurde am gleichen Tag wie die vorliegende Patentanmeldung eingereicht und besitzt das interne Aktenzeichen 08SGL0020DEP bzw. P3156.

Vorzugsweise ist das Material für den Konverter des Optik-Konverter-Systems wenigstens ein Material, welches in der Patentanmeldung mit dem Namen "Konversionsmaterial insbesondere für eine, eine Halbleiterlichtquelle umfassende weiße oder farbige Lichtquelle, Verfahren zu dessen Herstellung sowie dieses Konversionsmaterial umfassende Lichtquelle" beschrieben ist. Die genannte Patentanmeldung wurde am gleichen Tag wie die vorliegende Patentanmeldung eingereicht und besitzt das interne Aktenzeichen 08SGL0097DEP bzw. P3179.

Zur Verbesserung der Beleuchtung besitzt die Innenfläche oder -seite des Durchgangsbereichs in einer Ausführungsform zumindest abschnittsweise reflektierende Eigenschaften. Die reflektierenden Eigenschaften können zum einen durch ein entsprechendes Bearbeiten der Innenfläche, wie Polieren, erreicht werden. Als Alternative oder als Ergänzung kann die Innenfläche auch noch abschnittsweise beschichtet oder verkleidet sein. Metalle, wie zum Beispiel Silber, stellen ein bevorzugtes Material für eine solche Beschichtung oder Auskleidung dar. Der Durchgangsbereich oder das Kopfteil selbst kann somit auch als Reflektor bezeichnet werden.

Das opto-elektronische Funktionselement wird vorzugsweise über den Durchgangsbereich in das Gehäuse eingebracht und auf dem Basisteil befestigt. Das opto-elektronische Funktionselement ist ein strahlungsemittierendes und/oder strahlungsempfangendes Bauteil. Vorzugsweise ist das Funktionselement als Chip ausgebildet. Das Funktionselement ist wenigstens ein Bauteil ausgewählt aus der Gruppe von LED, Photodiode und Laserdiode. Die Verwendung des erfindungsgemäßen Gehäuses ist insbesondere für LEDs mit einer hohen Leistung, vorzugsweise mit einer Leistung von größer als etwa 5 W geeignet, da bei diesen eine effiziente Wärmeableitung erforderlich ist und das Gehäuse ausreichend thermisch stabil sein muss. Insbesondere auch für nicht opto-elektronische Funktionselemente, wie zum Beispiel Leistungshalbleiter, deren Verwendung insbesondere eine ausreichende thermische Stabilität erfordert, kann das vorliegende erfindungsgemäße Gehäuse geeignet sein. Somit kann das erfindungsgemäße Gehäuse auch ein Gehäuse für ein opto-elektronisches Funktionselement und/oder ein nicht opto-elektronisches Funktionselement sein. Entsprechendes gilt für das erfindungsgemäße Verfahren. Hierbei ist der Durchgangsbereich ein Bereich zum Einbringen oder Einführen des Funktionselements und/oder Bestandteil einer Kavität.

Das zumindest eine Funktionselement wird auf dem Basisteil angeordnet. Das Basisteil stellt zum einen das tragende Element für das Funktionselement dar. Das Basisteil kann somit auch als Träger oder Grundkörper bezeichnet werden. Das Basisteil kann hierbei einteilig oder in einzelne Bereiche unterteilt und somit segmentiert ausgebildet sein (siehe dazu nachfolgend).

Das Funktionselement ist nach dem Einbau in das Gehäuse in direktem Kontakt mit dem Basisteil. Die Oberseite des Basisteils, insbesondere des Montagebereichs ist hierbei im wesentlichen eben. Das Funktionselement kann zum Beispiel auf dem Basisteil aufgeklebt oder aufgelötet werden. Als Lote werden vorzugsweise bleifreie Weichlote verwendet. Der Kleber ist vorzugsweise ein leitfähiger Kleber, wie ein mit Silber angereicherter Epoxidharz. Somit wird über einen direkten Kontakt auch ein Kontakt über einen Kleber, Lot oder ein Bindemittel verstanden.

Da das Basisteil erfindungsgemäß auch einen Kühlkörper für das Funktionselement darstellt, umfasst dieses Materialien, welche eine entsprechende Leitfähigkeit für Wärme besitzen. Vorzugsweise besitzt das Basisteil eine Wärmeleitfähigkeit von zumindest etwa 50 W/mK, vorzugsweise von zumindest etwa 150 W/mK. Das Basisteil ist thermisch anschließbar an weitere Bauteile. Vorzugsweise umfasst das Basisteil wenigstens ein anorganisches Material oder besteht das Basisteil aus wenigstens einem anorganischen Material. In einer Version ist das Basisteil somit ein anorganisches oder im Wesentlichen anorganisches Basisteil. In einer Ausführungsform umfasst das Basisteil zumindest ein Metall oder ist ein Metall oder eine Legierung. Ein gängiges Metall ist zum Beispiel Kupfer und/oder Aluminium und/oder Nickel und/oder Eisen und/oder Molybdän und/oder Kupfer-Wolfram Materialien und/oder Cu-Molybdän Materialien. Es können aber auch Durchgänge oder Durchgangsleitungen, sogenannte thermische Vias, in dem Basisteil eingebracht oder angeordnet sein, wie zum Beispiel Kupfer-Vias in einer Platte, beispielsweise einer Ni/Fe-Platte.

In einer Weiterbildung der Erfindung ist das Basisteil in einer Art "Sandwich"-Bauweise und/oder "Mehrkomponenten"-Bauweise aufgebaut. Dazu ist das Basisteil aus wenigstens zwei Lagen aufgebaut. Die wenigstens zwei Lagen des Basisteils sind übereinander und/oder nebeneinander angeordnet. Das Basisteil ist in einer Ausgestaltung aus wenigstens einem erstem Material und einem zweiten Material aufgebaut ist. Das erste Material besitzt gegenüber dem zweiten Material eine erhöhte Wärmeleitfähigkeit. Das zweite Material besitzt gegenüber dem ersten Material einen niedrigeren thermischen Ausdehnungskoeffizienten.

Durch den mehrlagigen Aufbau und/oder den Aufbau aus wenigstens einem ersten und einem zweiten Material ist es insbesondere möglich, die thermische Ausdehnung des Basisteils an die thermische Ausdehnung der ersten Glasschicht anzupassen und eine entsprechende Wärmeabfuhr von dem Funktionselement zu ermöglichen. Dazu steht die Lage des Basisteils, die das erste Material umfasst, in einem thermischen Kontakt zu dem Funktionselement. Die Lage des Basisteils, die das zweite Material umfasst, ist angeordnet zur Anpassung der thermischen Ausdehnung des ersten Materials an die thermische Ausdehnung der ersten Glasschicht. Die Lage des zweiten Materials kann als Zwischenschicht und/oder als eine Art Rahmen in und/oder an dem Basisteil angeordnet sein.

In einer Ausgestaltung des Basisteils ist es, insbesondere an seiner Oberseite, zumindest abschnittsweise strukturiert. Dadurch können beispielsweise einzelne Abschnitte des Basisteils elektrisch isoliert bereitgestellt werden.

In einer weiteren Ausgestaltung ist das Basisteil derart aufgebaut, dass das erste Material in dem zweiten Material oder das zweite Material in dem ersten Material eingebettet ist.

In einer Ausführungsform besitzt das Basisteil zumindest einen, insbesondere elektrischen, Anschlussbereich für das Funktionselement. Dieser Bereich beschreibt einen Abschnitt des Basisteils, an welchem zum Beispiel ein Draht oder eine Leiterbahn befestigt werden kann. Über den Anschlussbereich kann eine Verbindung des Innenraums des Gehäuses oder des Funktionselement mit der Umgebung hergestellt werden. Sofern das Basisteil elektrisch leitfähig ist, kann der Anschlussbereich durch den Körper des Basisteils an sich bereitgestellt werden. Hierzu kann ein Vorsprung oder ein Lötansatz, eine sogenannte Lötfahne, an der Außenseite des Basisteils ausgebildet oder befestigt sein.

In einer Ausführungsform steht die Unterseite des Kopfteils in direktem Kontakt mit der ersten Glasschicht und/oder steht die Oberseite des Basisteils in direktem Kontakt mit der ersten Glasschicht. Vorzugsweise ist die erste Glasschicht zur Verbindung von Basisteil und Kopfteil direkt an der Unterseite des Kopfteils und an der Oberseite des Basisteils positioniert. Die erste Glasschicht grenzt sowohl an die Unterseite des Kopfteils als auch an die Oberseite des Basisteils. Vor dem Zusammenfügen werden das Basisteil und das Kopfteil so ausgerichtet, dass sich die Oberseite des Basisteils und die Unterseite des Kopfteils gegenüberliegen.

Eine 2-lagige Ausführung ermöglicht eine kostenreduzierte Herstellung von Gehäusen. In einer weiteren Ausführungsform umfasst das erfindungsgemäße Gehäuse oder der Verbund eine dritte Lage. Der erfindungsgemäße Verbund weist hierzu noch zumindest ein Anschlussteil auf, welches vorzugsweise zumindest mittels der ersten und/oder einer zweiten Glasschicht mit dem Verbund verbunden ist. Über das Anschlussteil erfolgt vorzugsweise zumindest eine oder die Kontaktierung des Funktionselements. Das Anschlussteil kann auch als Leiterbahn, Leiterband oder Leiterrahmen bezeichnet werden.

Das Anschlussteil erstreckt sich durch die Wand des Gehäuses. Es stellt dabei zumindest ein Bestandteil der Wand des Gehäuses bereit. Das Anschlussteil ragt in den Innenraum des Gehäuses, vorzugsweise den Durchgangsbereich, hinein und/oder in den Außenraum hinaus. Es ist vorzugsweise im wesentlichen mittig, insbesondere horizontal und/oder vertikal, in der Gehäusewand positioniert.

Über das Anschlussteil wird eine Verbindung des Innenraums des Gehäuses oder des Funktionselement mit der Umgebung hergestellt werden. An dem Bereich, welcher in den Innenraum zeigt oder ragt kann zum Kontaktieren zum Beispiel ein Draht oder eine Leiterbahn befestigt werden. An dem Bereich, welcher in den Außenraum zeigt oder ragt kann zum Kontaktieren zum Beispiel ebenso ein Draht oder eine Leiterbahn befestigt werden. Das Anschlussteil ragt vorzugsweise soweit in den Innenraum und/oder in den Durchgangsbereich hinein, dass das Empfangsvermögen und/oder das Emissionsverhalten des Funktionselements im wesentlichen nicht beeinträchtigt ist.

Vorzugsweise umfasst das Anschlussteil wenigstens ein anorganisches Material oder besteht das Anschlussteil aus wenigstens einem anorganischen Material. In einer Version ist das Anschlussteil somit ein anorganisches oder im Wesentlichen anorganisches Anschlussteil. In einer Ausführungsform umfasst das Anschlussteil ein oder ist das Anschlussteil ein elektrisch leitfähiges Material, vorzugsweise ein Metall oder eine Legierung. Das Metall ist hierbei zumindest ein Mitglied ausgewählt aus der Gruppe von Kupfer, Aluminium, Nickel, Eisen, Stahl oder Edelstahl, ferritischen Stahl oder Edelstahl und austenitischen Stahl oder Edelstahl. Das Anschlussteil unterstützt, bei entsprechender Wahl der Materialien, somit auch die Wärmeabfuhr.

In einer Ausführungsform ist das Anschlussteil zwischen der Unterseite des Kopfteils und der Oberseite des Basisteils angeordnet. Im Detail ist das Anschlussteil zwischen der ersten Glasschicht und der zweiten Glasschicht angeordnet. In einer Ausführungsform steht die Unterseite des Kopfteils in direktem Kontakt mit der zweiten Glasschicht und/oder steht die Oberseite des Anschlussteils in direktem Kontakt mit der zweiten Glasschicht. Die erste Glasschicht grenzt an die Unterseite des Anschlussteils und an die Oberseite des Basisteils.

Bei dem zumindest 3-lagigen System übernimmt das Kopfteil im wesentlichen die Funktion einer Lichtführung oder Fokussierung der von dem zu platzierenden Funktionselements emittierten und/oder zu empfangenden Strahlung. Die Kontaktierung des Funktionselements erfolgt im wesentlichen mittels des Anschlussteils. Bei dem 2-lagigen System übernimmt dagegen das Kopfteil im wesentlichen die Funktion einer Lichtführung und einer Kontaktierung.

Die Verwendung von Glas gegenüber den im Stand der Technik verwendeten Klebern ermöglicht eine verbesserte dauerhafte Verbindung und ein hermetisches Kapseln des Funktionselements im Gehäuse. Unter einer Glasschicht wird auch eine Glaslage verstanden. Die Glasschichten werden jeweils zwischen den entsprechenden Bauteilen angeordnet. Das erfindungsgemäße Gehäuse ist vorzugsweise ein anorganisches oder im Wesentlichen anorganisches Gehäuse.

Die für die Glasschichten verwendeten Gläser besitzen einen Erweichungspunkt oder eine Erweichungstemperatur in einem Bereich, der unterhalb der Schmelztemperatur der Materialien liegt, die für das Kopfteil, das Basisteil und/oder das Anschlussteil verwendet werden. Das Bereitstellen der ersten Glasschicht kann durch ein Aufbringen der ersten Glasschicht auf die Unterseite des Kopfteils und/oder auf die Oberseite des Basisteils erfolgen. Das Bereitstellen der zweiten Glasschicht kann durch ein Aufbringen der zweiten Glasschicht auf die Unterseite oder Oberseite des Anschlussteils erfolgen.

Das Glas bzw. die erste und/oder die zweite Glasschicht werden bereitgestellt durch Siebdrucken, durch Dispensen, mittels eines vorzugsweise gestanztes Glasbandes und/oder mittels eines individuellen Vorformlings. Ein Glasband kann zum Beispiel durch in die Form eines Bandes gegossenes Schlicker bereitgestellt werden. In einer Ausgestaltung werden die erste Glasschicht und/oder die zweite Glasschicht jeweils in einer Matrix bereitgestellt.

Insbesondere nachdem die Lagen gestapelt sind, wird das Glas, hier die erste Glasschicht und/oder die zweite Glasschicht, soweit erwärmt, dass das Glas eine Viskosität erreicht, dass das Glas an den jeweiligen Lagen anhaftet und die Lagen somit verbunden werden. Das Glas besitzt beim Verbinden vorzugsweise eine Viskosität in einem Bereich von 10⁷ Pas bis etwa 10³ Pas. Die jeweilige Glasschicht geht mit den angrenzenden Lagen eine stoffschlüssige Verbindung ein. Die Erwärmung erfolgt zum Beispiel in einem Ofen. Die Schichten können hierbei noch während der Erwärmung oder im Bereich der Erweichungstemperatur aneinander gepresst werden. Das "Kollabieren" der ersten und/oder der zweiten Glasschicht kann über die Temperatur und/oder die Zeit der Versiegelungssequenz gesteuert werden. Das Zusammenfügen oder Verkleben erfolgt über einen Zeitraum von etwa 5 min bis etwa 30 min, vorzugsweise von etwa 10 min bis 15 min. In diesem Zeitraum ist der im Glas vorhandene organische Binder und/oder Lösungsmittelrest im wesentlichen vollständig abgebrannt.

Vorzugsweise ist das Glas der ersten Glasschicht ein Phosphatglas und/oder ein Weichglas. Vorzugsweise ist das Glas der zweiten Glasschicht ebenso ein Phosphatglas und/oder ein Weichglas. Beispiele für ein Phosphatglas sind die Gläser mit der Bezeichnung SCHOTT G018-122. Beispiele für ein Weichglas sind die Gläser mit der Bezeichnung SCHOTT 8061 und/oder SCHOTT 8421. Phosphatgläser werden auf eine Temperatur in einem Bereich von etwa 300°C bis etwa 450°C erwärmt. Weichgläser werden auf eine Temperatur in einem Bereich von etwa 700°C bis etwa 900°C erwärmt. Eine niedrige Temperatur ermöglicht auf der einen Seite ein schnelleres und einfacheres Verarbeiten. Auf der anderen Seite sind die damit hergestellten Gehäuse nicht so chemisch stabil. Somit können verschiedene Bearbeitungen der einzelnen Lagen, wie zum Beispiel ein Plattieren, nicht mehr vorgenommen werden, wenn das Gehäuse zusammengebaut ist.

In einer Ausführungsform ist bzw. sind die erste Glasschicht und/oder die zweite Glasschicht, in dem Bereich, der an dem Anschlussteil anliegt, in ihrer Höhe reduziert. Die Reduzierung der Höhe ist derart, dass die Höhe oder Erstreckung des Anschlussteils im wesentlichen kompensiert ist. Das Anschlussteil ist somit zwischen der ersten und der zweiten Glasschicht sozusagen eingebettet. Sofern sich hierbei das eine Anschlussteil oder die Mehrzahl an Anschlussteilen nicht vollständig über,den Umfang um den Montagebereich und bis zum Rand des Gehäuses erstrecken, grenzen die erste und die zweite Glasschicht abschnittsweise direkt aneinander.

In einer weiteren Ausführungsform ist zwischen den Lagen wenigstens ein Abstandshalter angeordnet. Die Abstandshalter befinden sich nach dem Zusammenfügen in der Ebene der jeweiligen Glasschicht. Im Detail ist zwischen dem Basisteil und dem Kopfteil und/oder zwischen dem Basisteil und dem Anschlussteil und/oder zwischen dem Kopfteil und dem Anschlussteil wenigstens ein Abstandshalter angeordnet. Dadurch kann das "Kollabieren" oder Zusammenfallen der Glasschicht durch die Erweichung gezielt beschränkt und ein minimaler Abstand definiert werden. Die Höhe der jeweiligen Glasschicht kann somit gezielt eingestellt werden. Der Abstandshalter besitzt einen gegenüber dem Glas erhöhten Erweichungspunkt oder erhöhten Schmelzpunkt.

Der Abstandshalter ist in einer Ausgestaltung ein gesondertes Bauteil, welches vorzugsweise zwischen den Lagen angeordnet wird. Der Abstandshalter kann zum Beispiel eine Art Streifen sein. Mögliche Materialien für den Abstandshalter umfassen Metall, Keramik, Gläser mit einem gegenüber dem Glas zum Verbinden der Lagen erhöhten Erweichungspunkt.

In einer alternativen oder ergänzenden Ausführungsform ist der Abstandshalter durch eine entsprechende Ausgestaltung zumindest eines Abschnitts des Basisteils, des Kopfteils und/oder des Anschlussteils ausgebildet. Hierzu kann zum Beispiel in zumindest einem Abschnitt der Oberseite des Basisteils und/oder der Unterseite des Anschlussteils und/oder der Oberseite des Anschlussteils und/oder der Unterseite des Kopfteils eine Art Sockel oder Piedestal ausgebildet sein.

Form und Abmessungen der ersten und/oder der zweiten Glasschicht sind an die Form und die Abmessungen des Kopfteils, Basisteils sowie des Anschlussteils angepasst. Die erste Glasschicht und/oder die zweite Glasschicht erstrecken über den Umfang des Gehäuses. Im Inneren weisen sie jeweils eine Aussparung auf. Diese Aussparung stellt zum einen den Montagebereich bereit. Zum anderen kann sie auch Bestandteil des Durchgangsbereichs sein.

Das Gehäuse besitzt einen Aufsichtsfläche von etwa 5 mm² bis etwa 1000mm². In einer Aufsicht auf die Oberseite des Gehäuses liegt das Verhältnis der Fläche der ersten Glasschicht oder der zweiten Glasschicht zur Fläche des Gehäuses in einem Verhältnis von etwa 1/10 bis etwa 9/10, vorzugsweise von etwa 1/4 bis zu etwa 3/4. Dies ermöglicht einen stabilen Verbund und ein ausreichendes Hermetisieren. Um insbesondere eine gute Haftung und einen hermetischen Verbund zu ermöglichen besitzt bzw. besitzen die erste Glasschicht und/oder die zweite Glasschicht eine Dicke von etwa 100 µm bis 500 µm. Das Basisteil besitzt eine Höhe von etwa 0,2 mm bis etwa 2 mm. Das Kopfteil besitzt eine Höhe von etwa 0,2 mm bis etwa 2 mm. Das Anschlussteil besitzt eine Höhe von etwa 0,1 mm bis etwa 0,3 mm.

Um ein verbessertes Anhaften der Glasschichten an der jeweiligen Lage, im Detail an dem Kopfteil und/oder dem Basisteil und/oder dem Anschlussteil, zu bewirken, erfolgt eine Vorbehandlung der Glaskontaktflächen des Kopfteils und/oder des Basisteils und/oder des Anschlussteils. Die Vorbehandlung kann zum Beispiel ein Aufrauen der Glaskontaktfläche bewirken. Die Vorbehandlung kann zum Beispiel durch ein Anätzen und/oder Voroxidieren der Glaskontaktflächen erfolgen. Unter dem Voroxidieren wird ein gezieltes bzw. kontrolliertes Oxidieren einer Oberfläche, zum Beispiel in einer sauerstoffhaltigen Atmosphäre, verstanden. Zum Erzielen einer festen Verbindung zwischen den metallischen Bauteilen und den Glasschichten hat sich das Oxidieren als vorteilhaft erwiesen. Im Detail hat sich das Oxidieren der Oberseite des Basisteils und/oder der Unterseite des Kopfteils, d.h. der Glaskontaktflächen des Basisteils und/oder des Kopfteils, als sehr vorteilhaft erwiesen.

Dabei hat sich in überraschender Weise ein Verbund aus Glas und Kupfer oder Kupferoxid als sehr stabil erwiesen. Dazu wird bzw. werden in einer Ausführungsform wenigstens die Oberseite des Basisteils und/oder wenigstens die Unterseite das Kopfteils durch Kupfer bereitgestellt. In einer bevorzugten Ausführungsform der Erfindung sind in einem Gehäuse alle oder im Wesentlichen alle Metall-GlasKontaktflächen als Kupfer-Glas-Kontaktlächen oder als Kupferoxid-Glas-Kontaktlächen ausgebildet. Das Kupfer kann derart bereitgestellt werden, dass das Bauteil selbst aus Kupfer aufgebaut ist. Das Kupfer kann auch durch eine aufgebrachte Lage an Kupfer bereitgestellt werden. Diese Lage kann zum Beispiel mittels Galvanisieren, Laminieren und/oder Walzen aufgebracht werden. Phosphatglas und/oder Weichglas haben sich in Verbindung mit Kupfer als sehr vorteilhaft erwiesen.

Das Metall, vorzugsweise das Kupfer, wird hierzu in einer sauerstoffhaltigen Atmosphäre gezielt oxidiert. Dabei hat sich für das Oxidgewicht ein Flächengewicht von etwa 0,02 bis etwa 0,25 mg/cm², vorzugsweise von etwa 0,067 bis etwa 0,13 mg/cm², Oxidgewicht als vorteilhaft erwiesen. Das Oxid haftet gut und blättert nicht ab. Ab einem Flächengewicht vom etwa 0,27 mg/cm² Oxidgewicht "blättert" das Oxid ab. Ab einem Flächengewicht von etwa 0,5 mg/cm² Oxidgewicht, liegt ein "starkes" Oxid vor. Die Oxidschicht "springt" sozusagen von der Metalloberfläche ab.

Zur Verbesserung der jeweiligen Eigenschaften, zum Beispiel der Reflektivität, der Bondbarkeit und/oder der elektrischen Leitfähigkeit des Kopfteils, des Basisteils und/oder des Anschlussteils können diese auch noch beschichtet und/oder verkleidet sein. Ein Verfahren stellt das Plattieren dar. In Abhängigkeit von der Bearbeitungstemperatur und der Erweichungstemperatur der verwendeten Glassorte erfolgt die Beschichtung vor dem Zusammenfügen der einzelnen Lagen und/oder danach.

In einer Ausführung der Erfindung sind das Anschlussteil, der Anschlussbereich des Kopfteils und/oder der Anschlussbereich des Basisteils derart zusammengeführt, dass mittels einer einzigen Anode und/oder mittels einer einzigen Kathode eine Vielzahl von Funktionselementen versorgt werden kann oder versorgt wird.

In einer weiteren Ausführung sind eine Vielzahl von Funktionselementen an das Anschlussteil, den Anschlussbereich des Kopfteils und/oder den Anschlussbereich des Basisteils anschließbar oder angeschlossen, so dass mittels einer einzigen Anode und/oder mittels einer einzigen Kathode eine Vielzahl von Funktionselementen versorgt werden kann oder versorgt wird.

Das Kopfteil, das Basisteil und/oder das Anschlussteil wird bzw. werden jeweils, sofern sie aus einem metallischen Material gefertigt sind, durch ein sogenanntes Leiterrahmenverfahren hergestellt. Beispiele für ein solches Fertigungsverfahren sind photochemisches Ätzen, Stanzen, Laser-Schneiden und/oder Wasserstrahlschneiden. In einer Ausführungsform der Erfindung werden, insbesondere im Hinblick auf die günstigen Herstellungskosten, vorzugsweise nur stanzbare Materialien oder Metalle zur Herstellung des Basisteils des Anschlussteils und/oder des Kopfteils verwendet. In einer Ausführungsform wird eine Platte derart strukturiert, dass eine Vielzahl von Bauteilen pro Platte entsteht. Das Gehäuse ist Bestandteil einer Matrix von einzelnen Gehäusen. Eine Matrix ist dann eine Art Grundkörper, in welchem die jeweiligen Bauteil eingelagert oder angeordnet sind. Daher liegt im Bereich der vorliegenden Erfindung auch ein Anordnung oder eine Matrix, welche eine Vielzahl von Gehäusen, vorzugsweise der vorstehend beschriebenen Gehäuse, umfasst. Die einzelnen Gehäuse sind mittels sogenannter Stege oder Verbindungsstege an der jeweilige Matrix befestigt. Um ein späteres Vereinzeln zu erleichtern, können die einzelnen Gehäuse bereits von einzelnen Matrizen gelöst werden. Dies erfolgt nachdem der Verbund hergestellt ist. Es ist dann ausreichend, wenn das Gehäuse über das Basisteil, das Kopfteil und/oder das Anschlussteil an wenigstens einer Matrix befestigt ist. Die Anordnung ist somit dadurch gekennzeichnet, dass die Verbindung der Gehäuse zu mindestens einer Matrix, vorzugsweise im wesentlichen vollständig, gelöst ist.

Die Strukturierung der Matrix, welche die Anschlussteile bereitstellt, ist in einer Ausgestaltung so ausgeführt, dass die Anschlussteile derart zu einer Leitung zusammengeführt sind, dass mittels einer einzigen Anode und/oder mittels einer einzigen Kathode eine Vielzahl von Gehäusen und/oder Funktionselementen gleichzeitig versorgt werden. Im Detail sind die Anschlussteile, die Anschlussbereiche der Kopfteile und/oder die Anschlussbereiche der Basisteile der einzelnen Gehäuse derart zusammengeführt, dass mittels einer einzigen Anode und/oder mittels einer einzigen Kathode eine Vielzahl von Gehäusen versorgt werden kann. In einer weiteren Ausgestaltung sind das Anschlussteil, der Anschlussbereich des Kopfteils und/oder der Anschlussbereich des Basisteils eines einzelnen Gehäuses derart zusammengeführt, dass mittels einer einzigen Anode und/oder mittels einer einzigen Kathode eine Vielzahl von Funktionselementen in einem Gehäuse versorgt werden kann. Es sind zumindest zwei Anschlussteile pro Gehäuse vorgesehen, um mehrere Funktionselemente in einem Gehäuse zu versorgen.

Weiterhin erstreckt sich die Erfindung auf ein opto-elektronisches Bauteil, welches ein Gehäuse gemäß der vorliegenden Erfindung und wenigstens ein opto-elektronisches Funktionselement, insbesondere eine LED, welches in dem Gehäuse angeordnet ist, umfasst.

Ferner liegt im Rahmen der vorliegenden Erfindung auch eine Beleuchtungseinrichtung, welche wenigstens ein Gehäuse und/oder ein opto-elektronisches Bauteil gemäß der vorliegenden Erfindung beinhaltet. Beispiele für die Beleuchtungseinrichtung sind eine Sitzbeleuchtung; ein Leselicht; eine Arbeitsleuchte, die insbesondere in Decken oder Wänden integrierbar ist; eine Objektbeleuchtung in Möbeln und/oder Gebäuden; einen Scheinwerfer und/oder ein Rücklicht und/oder eine Innenbeleuchtung und/oder eine Instrumenten- oder Display-Beleuchtung, vorzugsweise in Kraftfahrzeugen; und/oder eine Hintergrundbeleuchtung für LCD-Displays.

Die vorliegende Erfindung wird anhand der nachfolgenden Ausführungsbeispiele im Einzelnen erläutert. Hierzu wird auf die beigefügten Zeichnungen Bezug genommen. Die gleichen Bezugszeichen in den einzelnen Zeichnungen beziehen sich auf die gleichen Teile.
Fig. 1.a und 1.b illustrieren in einer perspektivischen Ansicht das Zusammenfügen dreier Matrizen mit einer Mehrzahl an Bauteilen zur Herstellung von dreilagigen Gehäusen.
Fig. 2 zeigt schematisch die einzelnen Verfahrensschritte zur Herstellung des Gehäuses.
Fig. 3.a bis 3.d zeigen schematisch eine Detailansicht eines Ausschnitts einer Matrix mit darin angeordneten Gehäusen.
Fig. 4.a bis 4.j zeigen schematisch verschiedene Ausführungsformen des erfindungsgemäßen Gehäuses.
Fig. 5 illustriert das finale Aussehen eines Anschlussteils.
Fig. 6.a bis 6.c zeigen experimentelle Ergebnisse zur Haftung von Glas auf einem Metallstreifen (Fig. 6.a und 6.b) und zur Tiefenverteilung von Kupfer in Glas (Fig. 6.c).
Fig. 7.a bis 7.c zeigen schematisch eine Anordnung von Gehäusen (Fig. 7.a und 7.b) und eine Anordnung von LEDs in einem Gehäuse (Fig. 7.c).

### Detaillierte Beschreibung der Erfindung

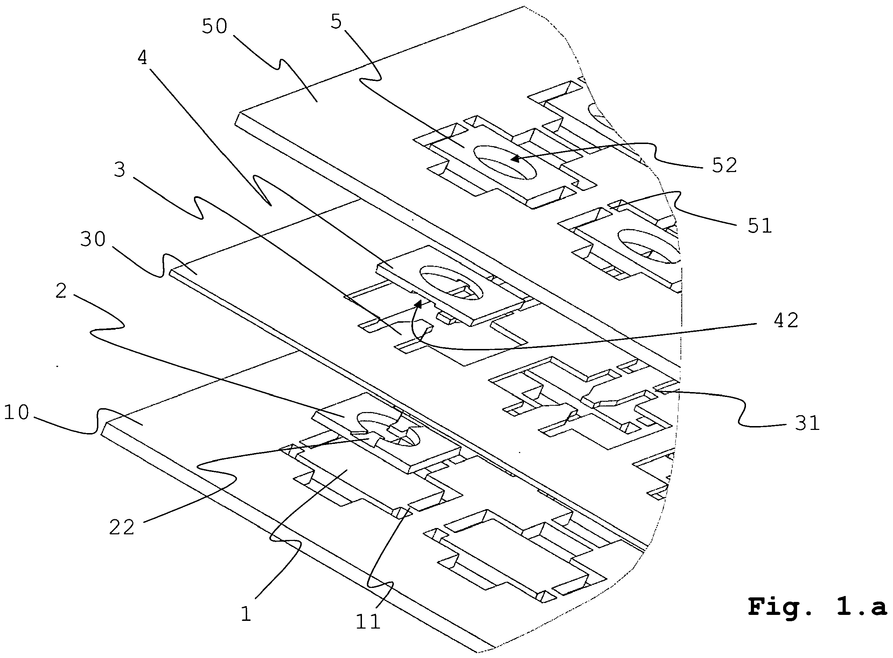

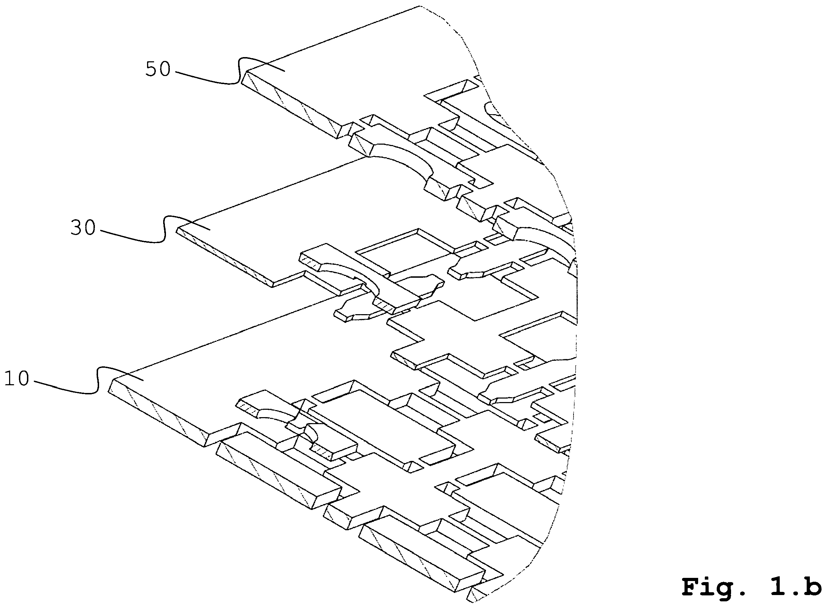

Die Figuren 1.a und 1.b illustrieren die einzelnen Bestandteile eines dreilagigen Systems vor seiner Herstellung. Figur 1.b zeigt Figur 1.a in ihrem Querschnitt. Das dreilagige System oder Gehäuse 100 besteht vorliegend aus einem Basisteil 1, zwei Anschlussteilen 3, welche in einer Ebene angeordnet sind, und einem Kopfteil 5, welches nachfolgend als Reflektor 5 bezeichnet wird, die über eine erste Glasschicht 2 und eine zweite Glasschicht 4 verbunden sind bzw. werden. Das Basisteil 1 wird mittels der ersten Glasschicht 2 mit den beiden Anschlussteilen 3, welche nachfolgend als Leiterbänder 3 bezeichnet werden, verbunden. Die Leiterbänder 3 selbst sind wiederum mittels der zweiten Glasschicht 4 mit dem Reflektor 4 verbunden.

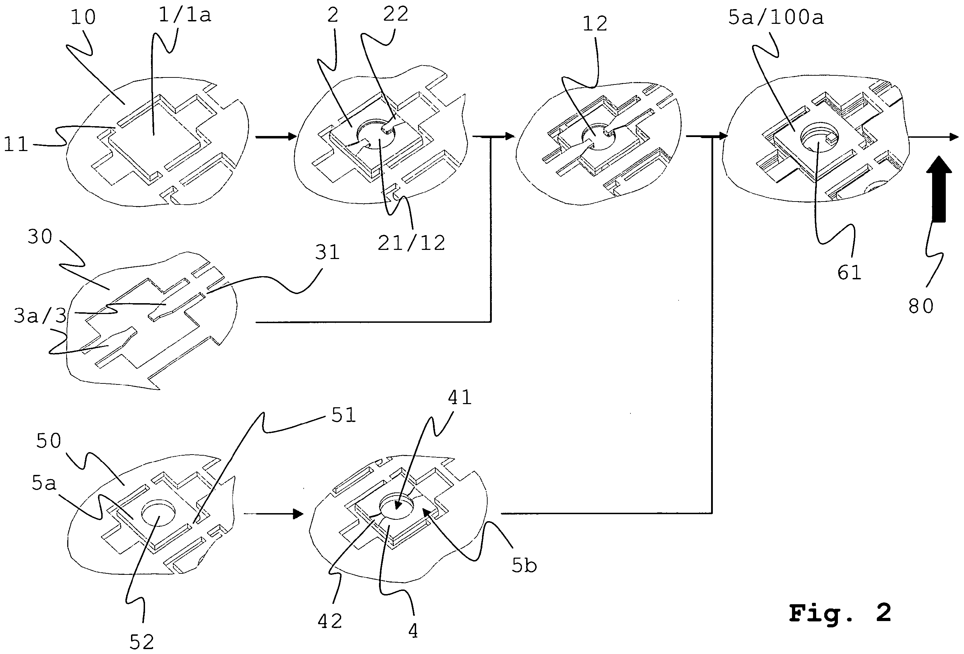

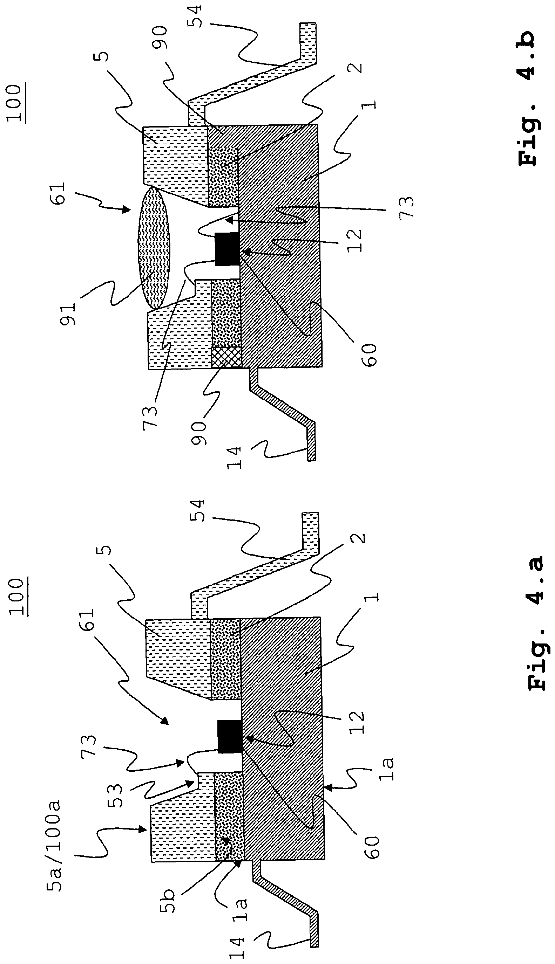

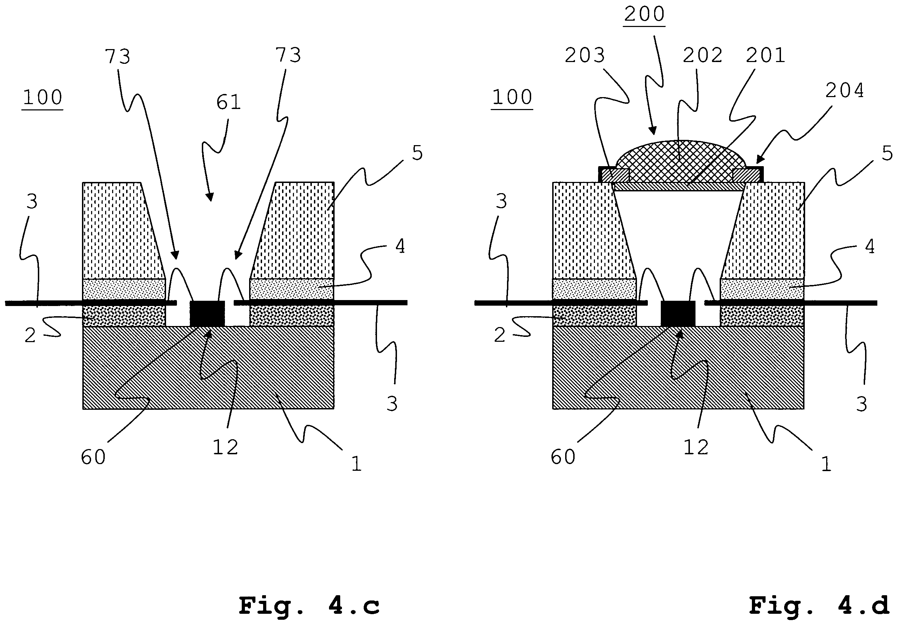

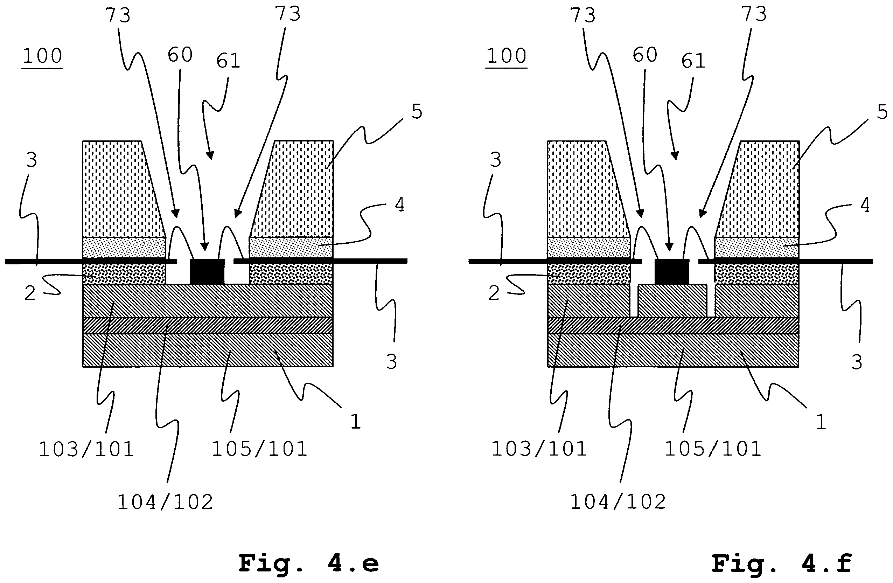

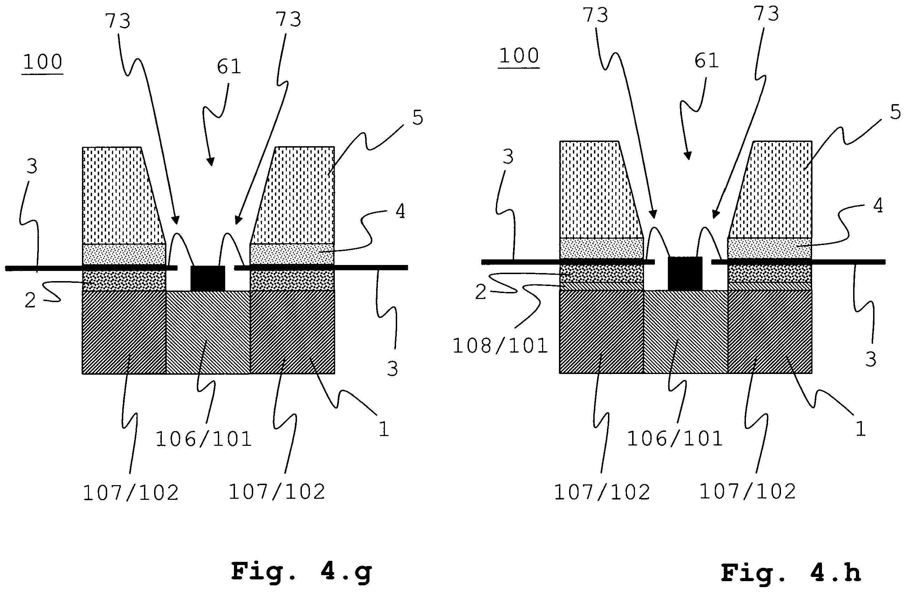

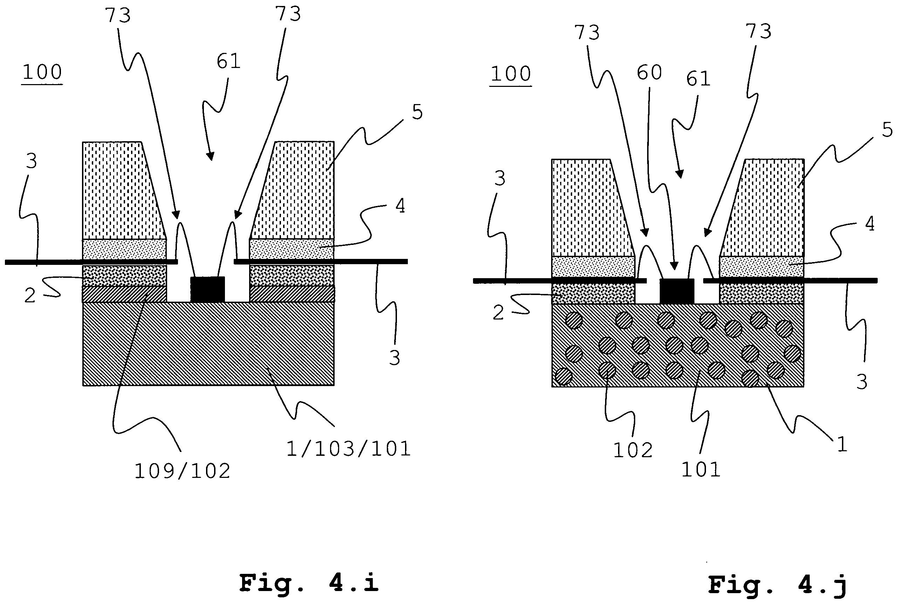

Um eine kostenreduzierte Herstellung von Gehäusen 100 zu ermöglichen, sind die Bauteile 1, 3, 5 jeweils in einer Matrix 10, 30, 50 angeordnet. Somit kann eine Vielzahl von Gehäusen 100 gleichzeitig hergestellt werden. Die Bauteile 1, 3, 5 sind vorliegend alle aus Metall gefertigt. Die jeweilige Matrix 10, 30, 50 wird durch ein Strukturieren einer Metallplatte hergestellt. Somit werden die Basisteile 1, die Kopfteile 3 und die Anschlussteile 5 jeweils durch eine strukturierte Metallplatte bereitgestellt. Eine Platte wird hierbei derart strukturiert, dass eine Vielzahl von Bauteilen 1, 3, 5 pro Platte 10, 30, 50 entsteht. Mögliche Verfahren zum Strukturieren stellen photochemisches Ätzen, Stanzen, Laser-Schneiden und/oder Wasserstrahlschneiden dar. Die Bauteile 1, 3, 5 sind an der jeweiligen Matrix 10, 30, 50 oder an dem jeweiligen Rahmen über sogenannte Verbindungsstege 11, 31, 51 oder Befestigungsstege 11, 31, 51 befestigt. Die vorstehend genannten Metallplatten können auch noch plattiert werden, zum Beispiel vor dem Strukturieren oder nach dem Strukturieren als Matrix. Für Details zu den einzelnen Verfahrensschritten sei auf die nachfolgende Figur 2 verwiesen. Mögliche Ausführungsformen der Gehäuse 100, die mit dem erfindungsgemäßen Verfahren hergestellt werden können, sind in den Figuren 4a bis 4.d illustriert.

Figur 2 illustriert die einzelnen Verfahrensschritte zur Herstellung der erfindungsgemäßen Gehäuse 100. Das Verfahren wird mit einer Vielzahl von Bauteilen in einer Matrix durchgeführt. Es wird jedoch nur anhand eines einzelnen Gehäuses 100 erläutert. Zunächst wird das Basisteil 1, welches den Träger und den Kühlkörper für eine zu platzierende LED 60 bildet, bereitgestellt. Auf der Oberseite 1a des Basisteils 1 wird die erste Glasschicht 2 aufgebracht. Ein mögliches Verfahren zum Aufbringen der ersten Glasschicht 2 stellt ein Siebdruckverfahren dar. Die erste Glasschicht 2 weist in ihrem Zentrum eine Aussparung 21 auf. Innerhalb dieser Aussparung 21 wird, vorzugsweise nach dem vollständigen Zusammenbau des Gehäuses 100, die LED 60 oder der LED-Chip montiert. Die "freigehaltene" Fläche auf dem Basisteil 1 oder ein Teil davon bildet den Montagebereich 12 für die LED 60. Die Aussparung 21 in der ersten Glasschicht 2 kann aber auch gleichzeitig ein Bestandteil des Durchgangsbereichs 61 sein. Die erste Glasschicht 2 erstreckt sich vollständig über den Umfang des Montagebereichs 12. Die Bereiche 22 der ersten Glasschicht 2, in welchen nachfolgend die beiden Leiterbänder 3 montiert werden, weisen eine reduzierte Höhe auf. Zudem erstreckt sich dieser Bereich 22 in das Zentrum des Gehäuses 100. Die Bereiche 22 reduzierter Höhe bilden, vorzugsweise im Wesentlichen vollständig, eine Anlage- oder Auflagefläche 22 für die Leiterbahnen 3.

In einem nächsten Verfahrensschritt wird die Matrix 30 mit den Leiterbahnen 3 bereitgestellt. Vorliegend wird das Gehäuse 100 mit zwei Anschlussteilen 3 oder Leiterbahnen 3 ausgestattet. Die Anschlussteile 3 werden derart auf der ersten Glasschicht 2 positioniert, dass sie auf den Bereichen 22 reduzierter Höhe zur Anlage kommen.

In einem nachfolgenden Verfahrensschritt wird der Reflektor 5 bereitgestellt. Der Reflektor weist in seinem Inneren eine Aussparung 52 auf. Diese Aussparung 52 bildet später den Durchgangsbereich 61 oder einen Bestandteil des Durchgangsbereichs 61. Auf der Unterseite 5b des Reflektors 5 wird eine zweite Glasschicht 4 angeordnet oder aufgebracht. Ein mögliches Verfahren zum Aufbringen dieser zweiten Glasschicht 4 ist wiederum ein Siebdruckverfahren. Die Glasschicht 4 weist ebenso eine Aussparung 42 im Zentrum und somit über dem Montagebereich 12 auf. Die zweite Glasschicht 4 kann eine einheitliche Höhe besitzen. Vorliegend weisen die Bereiche 42 der zweiten Glasschicht 4 eine reduzierte Höhe auf. Die Bereiche 42 reduzierter Höhe bilden, vorzugsweise im Wesentlichen vollständig, eine Anlage- oder Auflagefläche 42 für die Leiterbahnen 3.

In einem nachfolgenden Verfahrensschritt werden das Gefüge aus Basisteil 1, erster Glasschicht 2 und Leiterbändern 3 mit dem Gefüge aus zweiter Glasschicht 4 und Reflektor 5 zusammengeführt. Sie werden derart zusammengeführt, dass die zweite Glasschicht 4 abschnittsweise zwischen den Leiterbändern 3 und dem Reflektor 5 angeordnet ist. Da sich die beiden Leiterbänder 3 nicht vollständig über den Umfang des Gehäuses 100 erstrecken, treten auch die erste Glasschicht 2 und die zweite Glasschicht 4 in Kontakt.

Nachdem die einzelnen Lagen 1, 3, 5 sozusagen gestapelt sind, wird das Glas 2 und 4 so erhitzt, zum Beispiel durch Wärmestrahlung 80, dass es eine derart niedrige Viskosität erreicht, so dass die Lagen 1, 3, 5 miteinander verbunden werden. Es kann zusätzlich ein Druck zum Anpressen der Lagen 1, 3, 5 bereitgestellt werden. Für ein Phosphatglas ergibt sich hierbei ein Temperaturbereich von etwa 300 bis 450°C. Für ein Weichglas ergibt sich dagegen ein Temperaturbereich von etwa 700 bis 900°C. Das "Kollabieren" oder Zusammenfallen der Glasschichten 2 und 4 kann durch die Temperatur und die Zeit der Versiegelung gesteuert werden. Zusätzlich ist es möglich, sogenannte Abstandshalter 90 zwischen den einzelnen Lagen 1, 2, 3 zu platzieren, welche einen minimalen Abstand zwischen den einzelnen Lagen 1, 2, 3 definieren. Die Abstandshalter 90 können Bestandteil des Gehäuses 100 werden. Sie können aber auch auf der jeweiligen Matrix 10, 30, 50 angeordnet sein.

In Abhängigkeit von dem verwendeten Glas kann das optionale Plattieren der einzelnen Lagen 10, 20, 30 oder 1, 2, 3 vor oder nach dem Zusammenfügen erfolgen. Bei einem Glas niedriger Erweichungstemperatur, wie dem Phosphatglas, und der sich daraus ergebenden niedrigeren Versiegelungstemperatur werden vorzugsweise alle Metallkomponenten 10, 20, 30 oder 1, 2, 3 plattiert, bevor sie zu dem Gehäuse 100 zusammengefügt werden. Das stellt zudem die Flexibilität bereit, dass unterschiedliche Lagen 10, 20, 30 oder 1, 2, 3 mit unterschiedlichen Materialien beschichtet oder plattiert werden können, ohne dass eine Überdeckung, ein sogenanntes "Masking", oder andere kostenintensive, selektive Plattierungstechnologien verwendet werden müssen. Z. B. können die Leiterbänder 3 oder 30 mit Gold plattiert werden, um ein durchzuführendes Drahtbonden, sogenanntes "Wire Bonding", zu verbessern. Die anderen Lagen 1 und 5 oder 10 und 50 können z. B. mit Nickel plattiert werden. Ferner kann zum Beispiel Silber auf der Innenseite des Durchgangsbereichs 61 oder der Aussparung 52 bereitgestellt werden, um eine erhöhte Reflektivität zu ermöglichen.

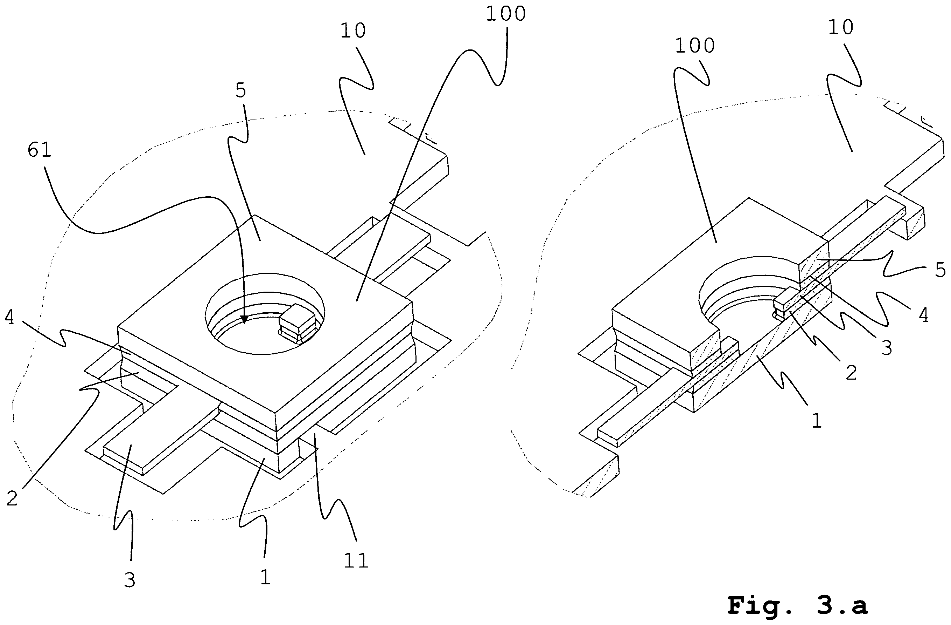

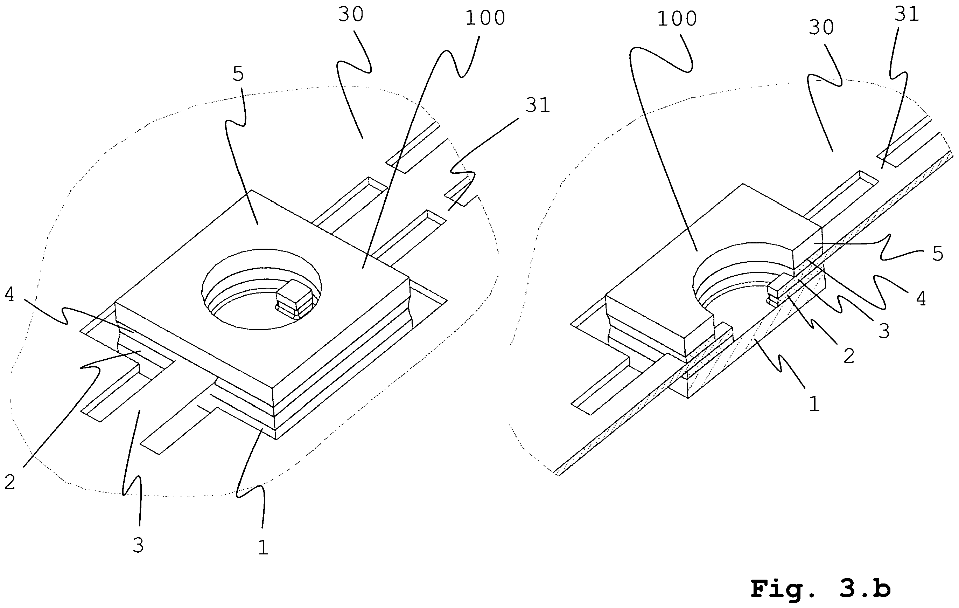

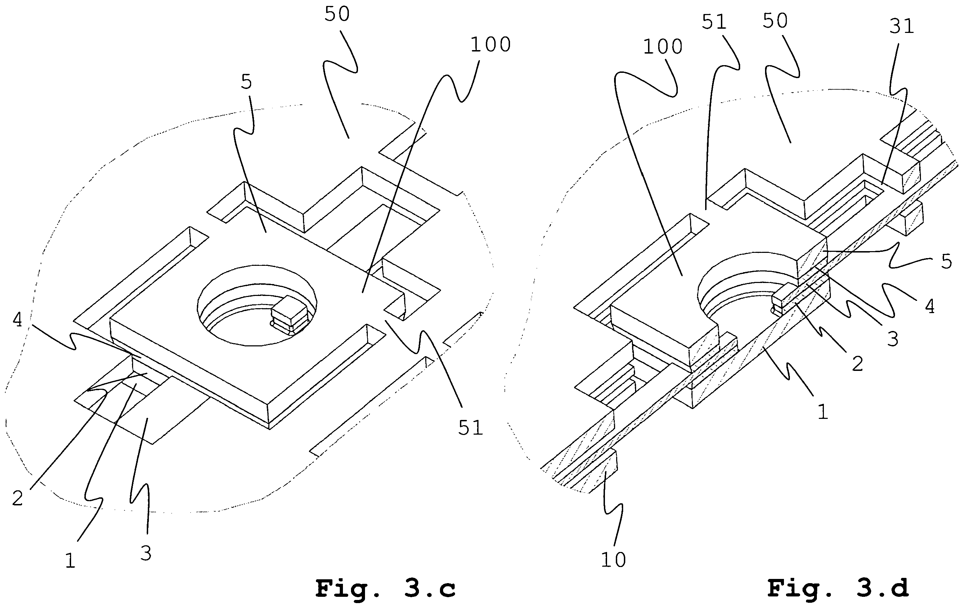

Nach dem Zusammenfügen der drei Matrizen 10, 30, 50 kann der gebildete Verbund direkt bereitgestellt werden, um z. B. eine Mehrzahl an LEDs über den Durchgangsbereich 61 auf dem Montagebereich 12 des jeweiligen Gehäuses 100 zu platzieren. Nach dem Zusammenfügen können die Gehäuse 100 aber auch vollständig oder teilweise von der jeweiligen Matrix 10, 30, 50 durch einen Trennvorgang, z. B. durch ein Schneiden, wie Laserschneiden, getrennt werden. Z. B. können bei einem dreilagigen System und somit drei verbundenen Matrizen 10, 30, 50 in zwei Matrizen 10 und 30 oder 10 und 50 oder 30 und 50 die Bauteile 1 und 3 bzw. 1 und 5 bzw. 3 und 5 herausgetrennt werden. In einem zweilagigen System und somit zwei verbundenen Matrizen 10 und 50 können in einer Matrix 10 oder 50 die Bauteile 1 bzw. 5 getrennt werden. In beiden Fällen verbleiben die Gehäuse 100 jeweils in einer Anordnung oder in einer Matrix. Somit kann eine Vielzahl von Gehäusen 100 auf der einen Seite in einfacher Weise gehandhabt werden. Auf der anderen Seite können die Gehäuse 100 in vereinfachter Weise vereinzelt werden, wie nach einem möglichen Prozess der LED-Montage, da diese nur noch an einer Matrix 10 oder 30 oder 50 befestigt sind. Ein mögliches Verfahren zum Trennen der Gehäuse 100 von der Matrix 10 oder 30 oder 50 stellt hierbei das Stanzen dar. Die einzelnen Möglichkeiten, wie eine Vielzahl von Gehäusen 100 bereitgestellt werden kann, sind in den Figuren 3a bis 3d illustriert. In Figur 3a ist perspektivisch jeweils eine Aufsicht (links) und ein Querschnitt (rechts) dargestellt. Hier sind die Gehäuse 100 nur noch über die Verbindungsstege 11 der Basisteile 1 in der Matrix 10, welche die Basisteile 1 bereitstellt, angeordnet. In Figur 3.b ist perspektivisch jeweils eine Aufsicht (links) und ein Querschnitt (rechts) dargestellt und zeigt eine Ausführungsform, in der die Gehäuse 100 über die hier zwei Anschlussteile 3 bzw. über die Verbindungsstege 31 in einer Matrix 30 angeordnet sind. Figur 3.c zeigt eine weitere Ausführungsform, in der die Gehäuse 100 über die Verbindungsstege 51 des Reflektors 5 an der Matrix 50 positioniert oder befestigt sind. Figur 3.d zeigt eine Ausführungsform, in der die Gehäuse 100 noch an allen drei Matrizen 10, 30 und 50 positioniert oder befestigt sind.

Die Figuren 4a bis 4c illustrieren in einem Querschnitt verschiedene Ausführungsformen eines Gehäuses 100 nach seiner Vereinzelung oder nach dem Heraustrennen aus der Verbundmatrix oder aus den zusammengefügten Matrizen 10, 30, 50. Figur 4.a zeigt ein 2-lagiges Gehäuse. Es besteht aus einem Kopfteil 5 und einem Basisteil 1, welche über eine erste Glasschicht 2 verbunden sind. Im Inneren des Gehäuses 100 ist eine LED 60 angeordnet. Die LED 60 ist auf dem Montagebereich 12, welcher durch einen Abschnitt der Oberseite 1a des Basisteils 1 bereitgestellt wird, positioniert. Oberhalb der LED 60 befindet sich der Durchgangsbereich 61 für das von ihr emittierte Licht. Die LED 60 weist vorliegend einen auf ihrer Vorderseite positionierten Kontakt und einen auf ihrer Rückseite positionierten Kontakt auf. Der vorderseitige Kontakt wird mit dem hier leitfähigen Reflektor 5 verbunden. Im Detail erfolgt die Verbindung mit einem Sockel 53, welcher im Bereich der Unterseite 5b des Reflektors 5 angebracht ist. Der Sockel 53 ist integral mit dem Reflektor 5. Die Kontaktierung wird durch einen Draht 73 hergestellt. Der rückseitige Kontakt wird durch die Auflage auf der Oberseite 1a des leitfähigen Basisteils 1 verbunden. Das Basisteil 1 ist zum Beispiel eine Kupferplatte. Durch die unmittelbare Positionierung der LED 60 auf der Oberseite 1a wird auch eine effiziente Wärmeableitung gewährleistet. Die "externe" Kontaktierung des Reflektors 5 und des Basisteils 1 erfolgt jeweils über die Anschlussbereiche 54 bzw. 13, wie zum Beispiel sogenannte Lötfahnen oder Leiterbahnen. Die Anschlussbereiche 54 und 14 sind jeweils integral mit dem Kopfteil 5 und dem Basisteil 1.

Das in Figur 4.b dargestellte Gehäuse 100 entspricht teilweise dem in Figur 4.a dargestellten Gehäuse 100. Im Unterschied dazu sind noch zwei Abstandshalter 90 zwischen der Unterseite 5b des Kopfteils 5 und der Oberseite 1a des Basisteils 1 angeordnet. Die Abstandshalter 90 sind in der Glasschicht 1 positioniert. Der links dargestellte Abstandshalter 90 ist ein separates Bauteil. Der rechts dargestellte Abstandshalter 90 ist zur Illustration, da dadurch vorliegend ein Kurzschluss gebildet werden würde, beispielhaft integral mit dem Basisteil 1 gebildet. Ein Abstandshalter kann, was hier jedoch nicht dargestellt ist, auch in einer Matrix, außerhalb der Gehäuses integriert, sein. Zudem ist noch ein optisches Bauteil 91, wie eine Linse 91, in dem Durchgangsbereich 61 angeordnet. Diese kann zum Beispiel geklemmt und/oder geklebt sein. Ferner ist eine LED 60 illustriert, deren beide Anschlüsse auf ihrer Oberseite liegen. Daher erfolgt noch ein zusätzliches Draht-Bonden 73, um den zweiten Kontakt der LED 60 an dem Anschlussbereich 1a des Basisteils 1, hier der Oberseite 1a des Basisteils 1, anzuschließen.

Figur 4.c illustriert ein dreilagiges Gehäuse. Es besteht aus einem oder umfasst einen Verbund aus dem Basisteil 1, der ersten Glasschicht 2, die beiden Anschlussteile 3, die zweite Glasschicht 4 und das Kopfteil 5.

Das in Figur 4.d dargestellte Gehäuse 100 entspricht dem in Figur 4.c dargestellten Gehäuse 100. Im Unterschied dazu ist noch ein Optik-Konverter-System 200 auf der Oberseite 100a des Gehäuses 100 angeordnet. Das Optik-Konverter-System 200 ist ein System wie in der vorstehend genannten Patentanmeldung 08SGL0020DEP bzw. P3156. Das Optik-Konverter-System 200 umfasst die oder besteht aus den folgenden Bestandteilen: Einen Konverter 201, ein optisches Bauelement 202, einen Ring 203, vorzugsweise aus Metall, als Träger und Verbinder mit einer Beschichtung 204, zum Beispiel mit einem Lötwerkstoff. Das Optik-Konverter-System 200 ist mit dem Gehäuse 100 zum Beispiel über eine Lötverbindung verbunden. Es wird ein hermetischer Verschluss gebildet.

Insbesondere für die "High Power Light Emitting Diodes" als Funktionselemente 60 erweist sich die Wärmeabfuhr von den Funktionselementen 60 als sehr entscheidend. Daher sind für das Basisteil 1 im Allgemeinen Metalle mit einer hohen Wärmeleitfähigkeit, wie Kupfer und Aluminium, im Einsatz. Aber die genannten Metalle besitzen auch den Nachteil, dass sie im Allgemeinen einen im Vergleich zu Glas erhöhten thermischen Ausdehnungskoeffizienten besitzen.

Während die vorstehend beschriebenen Ausführungsformen jeweils ein "einteiliges" Basisteils 1 zeigen, ist in den Figuren 4.e bis 4.j jeweils ein Basisteil 1 in einer Art "Sandwich"-Bauweise und/oder "Mehrkomponenten"-Bauweise dargestellt. Der jeweilige Aufbau entspricht dem in Figur 4.c dargestellten Gehäuse 100. Die Basisteile 1 der Gehäuse 100 sind jedoch nun zumindest aus einem erstem Material 101 mit hoher Wärmeleitfähigkeit und einem zweiten Material 102, mit einem gegenüber dem ersten Material 101 geringeren thermischen Ausdehnungskoeffizienten, aufgebaut. Durch diesen mehrlagigen und/oder mehrkomponentigen Aufbau des Basisteils 1 wird die größere thermische Ausdehnung des Metalls im Vergleich zu dem Glas der ersten Glasschicht 2, kompensiert. Um die erforderliche Wärmeabfuhr für das Funktionselement 60 zu erzielen, steht das Funktionselement 60 auch in einem thermischen Kontakt zu dem ersten Material hoher thermischer Wärmeleitfähigkeit. Das Funktionselement 60 liegt mittelbar oder unmittelbar auf dem ersten Material 101 auf.

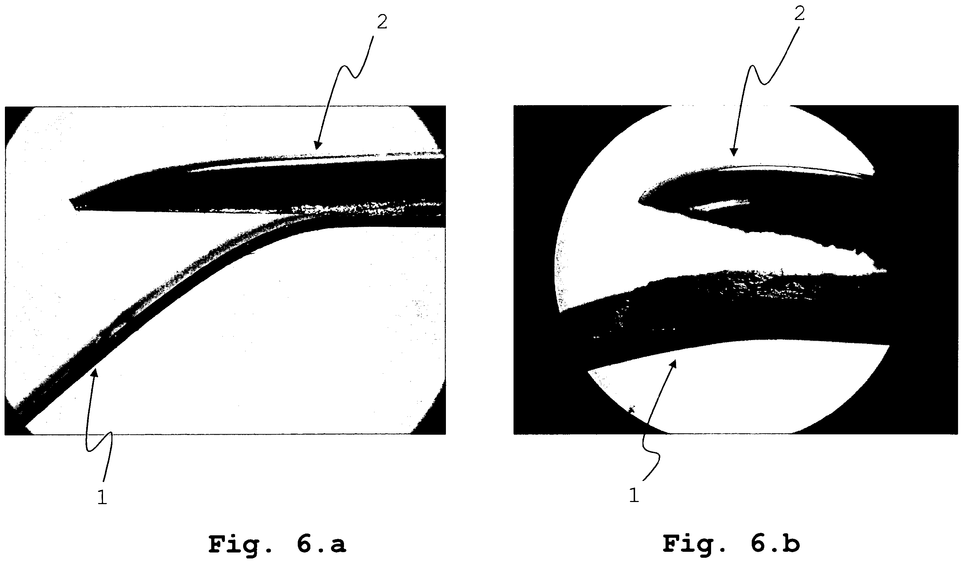

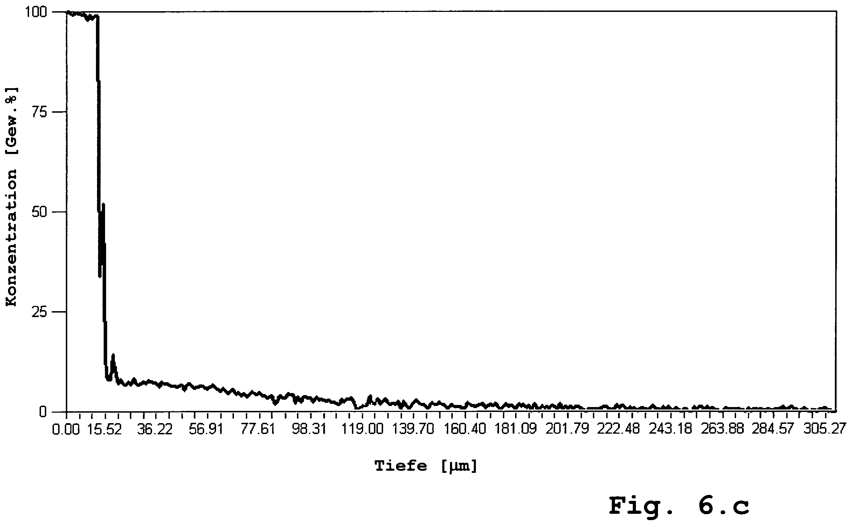

Kupfer hat sich als äußerst geeignet für das erste Material 101 erwiesen. Denn einerseits besitzt Kupfer eine gute Wärmeleitfähigkeit. Andererseits erweisen sich die Kupfer-Glas-Verbindungen oder Kupferoxid-Glas-Verbindungen als äußerst stabil. Zum Beleg sei hierzu auf die nachfolgende Beschreibung zu den Figuren 6.a und 6.b verwiesen. Zudem ist Kupfer gegenüber den verwendeten Gläsern chemisch stabil und besitzt einen ausreichend hohen Schmelzpunkt. Weiterhin ist Kupfer zu wirtschaftlich vertretbaren Kosten einzukaufen und/oder zu bearbeiten, insbesondere stanzbar. Kupfer bildet daher vorzugsweise immer einen Bestandteil des Basisteils 1.

Das zweite Material 102 besitzt vorzugsweise einen thermischen Ausdehnungskoeffizienten, welcher an den thermischen Ausdehnungskoeffizienten des ersten Materials 101 und/oder des verwendeten Glases der ersten Glasschicht 2 angepasst ist. Die Differenz der thermischen Ausdehnungskoeffizienten zwischen dem verwendeten Glas 2 und dem zweiten Material 102 beträgt im Allgemeinen weniger als 3ppm/°C. Vorzugsweise ist oder umfasst das zweite Material 102 ein Metall. Mögliche Beispiele stellen NiFe Legierungen, Molybdän und/oder Stahl dar.

In Figur 4.e ist das Basisteil 1 aus drei Lagen 103, 104, 105 aufgebaut. Um die entsprechende Wärmeabfuhr oder - spreizung für das Funktionselement 60 zu erzielen, ist die obere Lage 103 aus dem ersten Material 101 aufgebaut. Die untere dritte Lage 105 ist aus Symmetriegründen angeordnet und vorzugsweise ebenso aus dem ersten Material 101 aufgebaut. Um eine ausreichende Wärmeleitfähigkeit zu erhalten, haben die Lagen des ersten Materials 101, hier 103 und 105, eine Dicke von größer als 200 µm. Um die thermische Ausdehnung zu kompensieren, ist zwischen der oberen Lage 103 und der unteren Lage 105 eine Zwischenlage 104 oder -schicht aus dem zweiten Material 102 mit einem gegenüber dem ersten Material 101 reduzierten thermischen Ausdehnungskoeffizienten vorgesehen. Die Zwischenlage 104 "prägt" dem ersten Material 101 die erforderliche thermische Ausdehnung auf. Um den Wärmetransport zu erhalten ist die Zwischenlage 104 im Allgemeinen dünner als die äußeren Lagen 103 und 105 ausgebildet. Eine typische Dicke liegt in einem Bereich von etwa 80 bis 120 µm. Durch eine Variation der Schichtmaterialien und/oder der Schichtdicken ist es möglich, das thermische Ausdehnungsverhalten anzupassen. Aus Kostengründen ist das aus mehreren Lagen 103, 104, 105 aufgebaute Basisteil 1 beispielsweise mittels Walzen hergestellt.

Das in Figur 4.f dargestellte Gehäuse 100 entspricht dem in Figur 4.e dargestellten Gehäuse 100. Im Unterschied dazu ist die obere Lage 103 des Basisteils 1, die in Kontakt mit der ersten Glasschicht 2 steht, strukturiert ausgebildet. Das Funktionselement 60 ist auf eine Art Podest und dabei insbesondere elektrisch isoliert von dem äußeren Bereich der oberen Lage 103 des Basisteils 1 angeordnet.

Das in Figur 4.g dargestellte Gehäuse 100 entspricht dem in Figur 4.e dargestellten Gehäuse 100. Während in Figur 4.e ein horizontaler Schichtaufbau bzw. ein Schichtaufbau mit übereinander liegenden Lagen 103, 104 und 105 dargestellt ist, ist das in Figur 4.g dargestellte Basisteil 1 im Unterschied dazu in lateraler Richtung aus mehreren Lagen oder Schichten 106 und 107 aufgebaut. D.h. die Lagen 106 und 107 sind nebeneinander angeordnet. Das erste Material 101 ist in Kontakt mit dem Funktionselement 60 angeordnet. Es ist im Bereich des Zentrums 106 des Basisteils 1 als Zwischenlage 106 angeordnet. Das zweite Material 102 erstreckt sich als eine Art Rahmen 107 zumindest abschnittsweise über dem Umfang des Zentrums 106. Dieser Rahmen 107 "prägt" dem Zentrum 106 die thermische Ausdehnung auf oder kompensiert dessen starke Ausdehnung. Das Einbringen des ersten Materials 101 in das zweite Material 102 kann zum Beispiel mittels Rammen erfolgen.

In Figur 4.h ist ein Gehäuse 100 dargestellt, das dem in Figur 4.g dargestellten Gehäuse 100 entspricht. Auf dem zweiten Material 102 ist zusätzlich eine weitere Lage 108 als Haftvermittler angeordnet. Diese weitere Lage 108 ist insbesondere ein Ring 108. Der Ring 108 ist in bevorzugter Ausführung ein Kupferring mit oxidierter Oberfläche. Je nach Dicke dieser weiteren Lage 108 ist diese mittels Galvanisieren oder Laminieren auf dem Basisteil 1 aufgebracht. Vorzugsweise ist die weitere Lage 108 ein gestanztes Material. Dadurch wird ein Verbund mit erhöhter Stabilität zwischen dem Basisteil 1 und der ersten Glasschicht 2 hergestellt. Es kann auch noch zwischen der Unterseite 5b des Kopfteils 5 und der zweiten Glasschicht 4 eine weitere Lage, vorzugsweise aus Kupfer, als Haftvermittler angeordnet sein. Das ist in der Figur jedoch nicht dargestellt. Da in diesem Bereich eine hohe Wärmeleitfähigkeit nicht erforderlich ist, kann diese Lage 108 mit einer geringeren Dicke in einem Bereich von 5 bis 10 µm ausgebildet sein.

In Figur 4.i ist eine Weiterbildung der Erfindung gezeigt, in welcher das Basisteil 1 im Wesentlichen durch eine Lage 103 des ersten Materials 101 gebildet wird. Um die erforderliche Ausdehnung anzupassen, ist eine Lage 109 des zweiten Materials 102, beispielsweise als ein Ring 109, auf der Oberseite 1a des Basisteils 1 angeordnet. Ein Ring kann aber auch an der Unterseite 1b des Basisteils 1 angeordnet sein (in den Figuren nicht dargestellt).

Figur 4.j zeigt eine Ausführungsform des Gehäuses 100, in dem das Basisteil 1 durch ein "Matrix"-Material, in dem zum Beispiel entsprechende Materialien eingebettet sind, gebildet wird. Es sind Materialien miteinander kombiniert, welche in "Summe" oder in Kombination die erforderliche Wärmeleitfähigkeit und die erforderliche an das verwendete Glas angepasste thermische Ausdehnung besitzen. Zum Beispiel kann das Material für das Basisteil 1 mittels Sintern hergestellt sein. In der gezeigten Ausgestaltung sind Partikel des zweiten Materials 102, wie zum Beispiel Molybdän, in eine Matrix des ersten Materials 101, wie zum Beispiel eine Kupfermatrix, eingebettet.

Durch ein Zusammenwirken des Optik-Konverter-Systems 200, insbesondere des Konverters 201, mit der LED 60 ergibt sich in einer Ausführungsform eine sogenannte weiße LED 60. Von einem Empfänger wird das ausgehende Licht als weißes Licht wahrgenommen. Es wird eine sogenannte (W)LED 60 gebildet. Das weiße Licht wird aus einer additiven Farbmischung gebildet. Die LED 60 ist zum Beispiel eine blau emittierende LED 60 und der Konverter 201 ein Glas, das einen Lumineszensfarbstoff, wie sogenannten gelben Phosphor, enthält. Das kurzwellige blaue Licht regt den Farbstoff zum Leuchten an. Dieser Effekt wird als Photolumineszens bezeichnet. Dabei wird ein langwelligeres gelbes Licht abgegeben. Im Allgemeinen wird nicht das gesamte blaue Licht umgewandelt. Somit resultiert aus einer additiven Farbmischung der beiden Spektralfarben blau und gelb das weiße Licht.

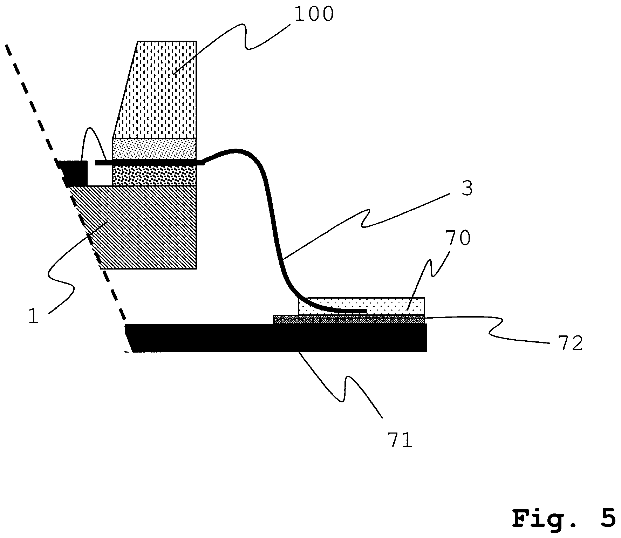

Figur 5 zeigt einen Ausschnitt eines Gehäuses 100 mit einer Detailansicht eines Anschlussteils 3. Das Gehäuse 100 kann z. B. auf einer Halterung 71 oder Platine 71 montiert sein. Die elektrische Kontaktierung des nicht dargestellten Funktionselements 60 erfolgt z. B. über das Anschlussteil 3 und eine Leiterbahn 72 der Platine 71, welche mittels einer Lötverbindung 71 verbunden sind. Das Anschlussteil 3 ist hierbei zu seiner finalen Form gebogen. Das Gehäuse 100 oder das Basisteil 1 des Gehäuses 100 ist mechanisch so stabil, dass ein Verbiegen des Anschlussteils 3 möglich ist, ohne das gesamte Gehäuse 100 zu verbiegen.

Gegenüber den bekannten Gehäusen ist das erfindungsgemäße Gehäuse 100 thermisch äußerst stabil. Das Gehäusedesign ermöglicht, bei höheren Arbeitstemperaturen zu arbeiten, als dies bei den gewöhnlichen Harzen und Kunststoffen im Stand der Technik möglich ist. Daher können auch "bleifreie" Löttechniken verwendet werden, welche im Allgemeinen eine erhöhte Verarbeitungstemperatur (oberhalb von 200°C) erfordern. Das Design stellt somit mehrere Optionen für einen Aufbau eines solchen Gehäuses 100 bereit. Dies bietet zusätzliche Optionen, insbesondere beim Löten, zum Befestigen des Funktionselements 60 auf dem Basisteil 1. Zudem wird eine hermetische Verkapselung ermöglicht.

Weiterhin zeichnen sich insbesondere die Ausführungsformen, bei den denen die Verbindung über Kupfer, insbesondere die Kupferoxidschicht, und Glas erfolgt, durch eine erhöhte Haftung zwischen dem Glas und dem Kupfer, insbesondere mittels der Kupferoxidschicht, aus. Dazu zeigen die Figuren 6.a bis 6.b jeweils experimentelle Ergebnisse zur Haftung von Glas auf einem Metallstreifen. Im Detail ist das "Abschälverhalten" einer Glasperle dargestellt, zum einen auf einem NiFe-Streifen (Fig. 6.a) und zum anderen auf einem auf Kupfer-Streifen mit einer Oxidschicht des Flächengewichts von etwa 0,1 mg/cm² (Fig. 6.b). Bei dem NiFe-Streifen springt die Glasperle ab einer gewissen Belastung, hier ab einem gewissen Biegewinkel, "vollständig" von dem Streifen ab. Die Oberfläche des NiFe-Streifens ist unverändert. Im Gegensatz dazu erfolgt bei dem Kupferstreifen der Abriss nicht am Glas/Metall-Interface sondern quer durch das Glas hindurch. Das Glas bleibt auf dem Kupfer haften. D.h. das Glas "zerreißt" eher als dass es sich von der Oberfläche löst. Somit liegt eine hervorragende Haftung vor.

Ohne an eine Theorie gebunden zu sein, gehen die Erfinder von der Annahme aus, dass die Oxidschicht auf dem Kupfer eine wesentlichen Einfluss auf die Haftung besitzt. Das Kupferoxid wird beim Verbinden vom Kupfer mit dem Glas zum Teil gelöst. Das Kupferoxid diffundiert in das Glas hinein. Es bildet sich eine Gradientenschicht aus. Die Menge an Kupferoxid in Glas nimmt von der Oberfläche in das Volumen des Glases hinein ab. In überraschender Weise liegt eine Diffusion des Kupferoxids in das Glas hinein bis zu einer Tiefe von bis zu etwa 200 µm vor. Dazu ist in Figur 6.c als Beispiel die Eindringtiefe von Kupfer in das Glas S-8061 gezeigt. Die Messung erfolgte mittels energiedispersiver Röntgenanalyse (EDX). Es ist die gemessene Tiefenverteilung bzw. die Konzentration des Kupfers als Funktion der Tiefe dargestellt (normiert auf die Konzentration des Kupfers an der Oberfläche). Die Konzentration direkt am Interface hängt von der Oxiddicke vor dem Aufschmelzprozess zum Verbinden ab. Sie kann mehrere Prozent betragen. Im Allgemeinen liegt die Konzentration des Kupfers an dem Interface in einem Bereich etwa 0,1 bis etwa 15%.

Ein mit dem erfindungsgemäßen Verfahren hergestelltes Gehäuse 100 bietet zudem weitere Vorteile gegenüber den bekannten Gehäusen. Hierbei können auch Anforderungen, wie sie bei der Verarbeitung von LEDs erforderlich sind, erfüllt werden. Als Basis 1 oder Basisteil 1 kann ein Material mit hoher thermischer Leitfähigkeit bereitgestellt werden. Die von einer LED produzierte Wärme kann von dem Kühlkörper, der durch das Basisteil bereitgestellt wird, effizient verteilt und abgeleitet werden, da die zu platzierende LED in direktem Kontakt mit dem Kühlkörper, hier der Basis 1, steht. Die Verpackung ist im wesentlichen frei von organischen Materialien. Das Verfahren ist kompatibel mit sogenannten SMD-Verfahren ("Surface Mountable Device"). Die Herstellung und die Lieferung von Gehäusen 100 in Matrixform ist möglich. Das Verfahren ermöglicht eine kostenreduzierte Herstellung. Das Design mit kegelförmigen, teilweise gestuften Reflektoren und/oder die Möglichkeit einer Kombination mit Glaslinsen und/oder Optik-Konverter-Systemen 200 ist möglich.

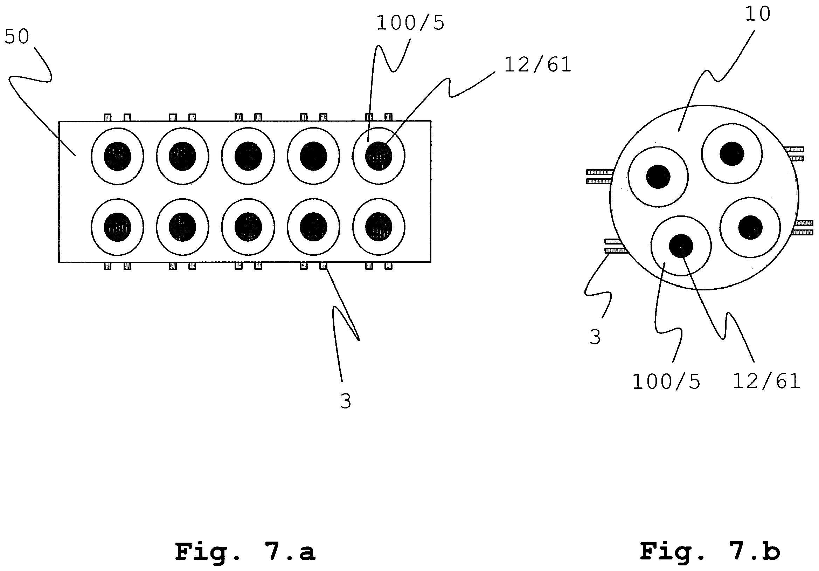

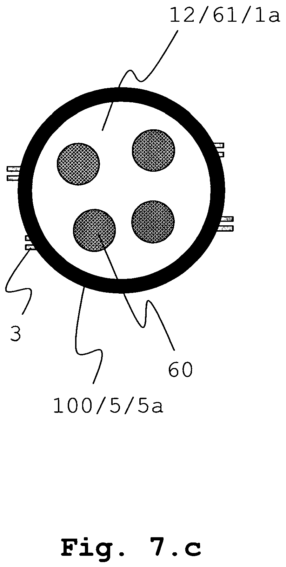

Die Figuren 7.a und 7.b illustrieren jeweils eine Gruppierung oder eine Vielzahl von Gehäusen 100 gemäß der vorliegenden Erfindung. Solche sogenannten Arrays sind unter anderem wichtig für kommerzielle Verwendungen, wie z. B. im Automobilbereich für einen Scheinwerfer und/oder ein Rücklicht und/oder eine Innenbeleuchtung. Vorliegend sind die Gehäuse 100 beispielhaft in einer runden Form dargestellt. Das Array kann darüber erzielt werden, dass die Gehäuse 100 in einer Matrix 10 und 50, wie in den Figuren 3.a bis 3.c illustriert, gehalten werden. Die Anschlussteile 3 der einzelnen Gehäuse können derart zusammengeführt sein, dass mittels einer einzigen Anode und/oder mittels einer einzigen Kathode eine Vielzahl von Gehäusen betrieben werden können. Figur 7.c illustriert dagegen eine Gehäuse 100, in welchem eine Vielzahl an LEDS 60, hier beispielhaft vier LEDs 60, in einem Gehäuse 100 angeordnet ist. Alle LEDs 60 sind auf dem Montagebereich 12 innerhalb des Gehäuses 100 angeordnet. Die LEDs 60 können, wie dargestellt, jeweils einen eigenen Anschluss 3 oder eine eigene Zuleitung 3, zum Beispiel mit zumindest zwei Leitungen, haben. Die Anschlüsse 3 der einzelnen LEDs 60 können aber auch zusammengeführt oder teilweise zusammengeführt werden, so dass das Gehäuse 100 nur einen einzelnen Anschluss 3 für alle LEDs besitzen kann. Hierbei können auch die Drähte 73 der einzelnen LEDs 60 zu einem Anschluss 3 oder zwei Anschlüssen 3 geführt werden.

Es ist dem Fachmann ersichtlich, dass die beschriebenen Ausführungsformen beispielhaft zu verstehen sind. Die Erfindung ist nicht auf diese beschränkt, sondern kann in vielfältiger Weise variiert werden, ohne den Schutzumfang der Erfindung zu verlassen, der in den unabhängigen Ansprüchen 1 und 13 definiert ist

### Bezugszeichenliste

- 1: Basisteil oder Basis oder Träger
- la: Oberseite des Basisteils
- 1b: Unterseite des Basisteils

- 2: Erste Glasschicht oder Glaslage

- 3: Anschlussteil oder Leiterband
- 3a: Oberseite des Anschlussteils
- 3b: Unterseite des Anschlussteils

- 4: Zweite Glasschicht oder Glaslage

- 5: Kopfteil oder Reflektor
- 5a: Oberseite des Kopfteils
- 5b: Unterseite des Kopfteils

- 10: Matrix für das Basisteil
- 11: Verbindungssteg Basisteil-Matrix
- 12: Montagebereich für das Funktionselement
- 13: Anschlussbereich des Basisteils

- 21: Aussparung in der ersten Glasschicht
- 22: Auflagebereich für das Anschlussteil

- 30: Matrix für das Anschlussteil
- 31: Verbindungssteg Anschlussteil-Matrix

- 41: Aussparung in der zweiten Glasschicht
- 42: Auflagebereich für das Anschlussteil

- 50: Matrix für das Kopfteil
- 51: Verbindungssteg Kopfteil-Matrix
- 52: Aussparung im Kopfteil
- 53: Funktionselementanschlussbereich oder Sockel
- 54: Anschlussbereich des Kopfteils

- 60: Opto-elektronisches Funktionselement oder LED
- 61: Durchgangsbereich

- 70: Lötverbindung
- 71: Halterung oder Platine
- 72: Leiterbahn der Platine
- 73: Draht oder Draht-Bonding

- 80: Wärme oder Wärmestrahlung

- 90: Abstandshalter
- 91: Optisches Bauteil oder Linse

- 100: Gehäuse oder Funktionselementgehäuse
- 100a: Oberseite des Gehäuses

- 101: Erstes Material mit hoher Wärmeleitfähigkeit
- 102: Zweites Material mit geringerer Wärmeausdehnung
- 103: Obere oder äußere Lage des Basisteils
- 104: Zwischenlage des Basisteils
- 105: Untere oder äußere Lage des Basisteils
- 106: Zentrum des Basisteils
- 107: Rahmen des Basisteils
- 108: Weitere Lage oder Ring aus dem ersten Material
- 109: Weitere Lage oder Ring aus dem zweiten Material

- 200: Optik-Konverter-System oder Konverterbaustein
- 201: Konverter
- 202: Optisches Bauelement oder Optik
- 203: Ring oder Metallring oder Metallträger
- 204: Beschichtung oder Auskleidung

## Patentansprüche

1. Gehäuse (100) für ein opto-elektronisches Funktionselement (60), insbesondere eine LED (60), umfassend
- einen Verbund zumindest aus einem Basisteil (1) und einem Kopfteil (5) und
- ein Abschnitt der Oberseite (1a) des Basisteils (1) einen Montagebereich (12) für zumindest ein optoelektronisches Funktionselement (60) definiert, so dass das Basisteil (1) einen Kühlkörper für das opto-elektronische Funktionselement (60) bildet und
- das Kopfteil (5) sich zumindest abschnittsweise über den Umfang des Montagebereichs (12) erstreckt und über dem Montagebereich (12) einen Durchgangsbereich (52,61) für die von dem opto-elektronischen Funktionselement (60) emittierte und/oder zu empfangende Strahlung bildet, wobei
- das Kopfteil (5) ein Metall umfasst und das Basisteil (1) ein Metall umfasst wobei das Basisteil (1) und das Kopfteil (5) zumindest mittels einer ersten Glasschicht (2), welche zwischen der Oberseite (1a) des Basisteils (1) und der Unterseite (5b) des Kopfteils (5) angeordnet ist, verbunden sind, **dadurch gekennzeichnet**
**dass** die Oberseite (1a) des Basisteils (1) voroxidiert ist und/oder die Unterseite (5b) des Kopfteils (5) voroxidiert ist,
wobei zumindest die Oberseite (1a) des Basisteils (1) und/oder zumindest die Unterseite (5b) des Kopfteils (5) durch Kupfer bereitgestellt ist bzw. sind und
die Oberseite (1a) des Basisteils (1) und/oder die Unterseite (5b) des Kopfteils (5) derart voroxidiert ist bzw. sind, so dass eine Oxidschicht mit einem Flächengewicht von 0,067 mg/cm² bis 0,13 mg/cm², ausgebildet ist.

2. Gehäuse nach vorstehendem Anspruch **dadurch gekennzeichnet,**
**dass** das Basisteil (1) aus wenigstens zwei Lagen (103, 104, 105, 106, 107, 108, 109) aufgebaut ist oder
**dass** das Basisteil (1) aus wenigstens zwei Lagen (103, 104, 105, 106, 107, 108, 109) aufgebaut ist und die wenigstens zwei Lagen (103, 104, 105, 106, 107, 108, 109) des Basisteils (1) übereinander und/oder nebeneinander angeordnet sind.

3. Gehäuse nach einem der vorstehenden Ansprüche **dadurch gekennzeichnet,**
**dass** das Basisteil (1) aus wenigstens einem erstem Material (101) und einem zweiten Material (102) aufgebaut ist oder
**dass** das Basisteil (1) aus wenigstens einem erstem Material (101) und einem zweiten Material (102) aufgebaut ist und das erste Material (101) gegenüber dem zweiten Material (102) eine erhöhte Wärmeleitfähigkeit besitzt und das zweite Material (102) gegenüber dem ersten Material (101) einen niedrigeren thermischen Ausdehnungskoeffizienten besitzt.

4. Gehäuse nach einem der vorstehenden Ansprüche **dadurch gekennzeichnet,**
**dass** die Lage (103, 106) des Basisteils (1), die das erste Material (101) umfasst, in einem thermischen Kontakt zu dem Funktionselement (60) steht und/oder
**dass** die Lage (103, 106) des Basisteils (1), die das zweite Material (102) umfasst, zur Anpassung einer thermischen Ausdehnung des ersten Materials (101) an die erste Glasschicht (2) angeordnet ist und/oder
**dass** das Basisteil (1), insbesondere an seiner Oberseite (la), zumindest abschnittsweise strukturiert ist und/oder
**dass** das Basisteil (1) derart aufgebaut ist, dass das erste Material (101) in dem zweiten Material (102) oder das zweite Material (102) in dem ersten Material (101) eingebettet ist.

5. Gehäuse nach einem der vorstehenden Ansprüche **dadurch gekennzeichnet,**
**dass** das Kopfteil (5) zumindest einen Anschlussbereich (53) für das Funktionselement (60) aufweist oder
**dass** das Kopfteil (5) zumindest einen Anschlussbereich (53) für das Funktionselement (60) aufweist und der Anschlussbereich (53) an einer Innenseite des Kopfteils (5) als eine Art Sockel (53) ausgebildet ist.

6. Gehäuse nach einem der vorstehenden Ansprüche **dadurch gekennzeichnet,**
**dass** die Innenseite des Durchgangsbereichs (52, 61) zumindest abschnittsweise reflektierende Eigenschaften hat und/oder
**dass** das Basisteil (1) zumindest einen Anschlussbereich (1a) für das Funktionselement (60) besitzt.

7. Gehäuse nach einem der vorstehenden Ansprüche **dadurch gekennzeichnet,**
**dass** wenigstens ein Anschlussteil (3) zwischen der Unterseite (5b) des Kopfteils (5) und der Oberseite (1a) des Basisteils (1) angeordnet ist oder
**dass** wenigstens ein Anschlussteil (3) zwischen der Unterseite (5b) des Kopfteils (5) und der Oberseite (1a) des Basisteils (1) angeordnet ist und das Anschlussteil (3) zumindest mittels der ersten Glasschicht (2) und/oder einer zweiten Glasschicht (4) mit dem Verbund verbunden ist und/oder
**dass** das Anschlussteil (3) zwischen der ersten Glasschicht (2) und einer zweiten Glasschicht (4) angeordnet ist.

8. Gehäuse nach einem der vorstehenden Ansprüche **dadurch gekennzeichnet,**
**dass** die erste Glasschicht (2) und/oder die zweite Glasschicht (2), in dem Bereich (22), der an dem Anschlussteil (3) anliegt, in ihrer Höhe reduziert ist bzw. sind und/oder
**dass** zwischen dem Basisteil (1) und dem Kopfteil (5) und/oder zwischen dem Basisteil (1) und dem Anschlussteil (3) und/oder zwischen dem Kopfteil (5) und dem Anschlussteil (3) wenigstens ein Abstandshalter (90) angeordnet ist und/oder
**dass** das Verhältnis der Fläche der ersten Glasschicht (2) oder der zweiten Glasschicht (4) zur Fläche des Gehäuses (100) in einem Verhältnis von etwa 1/10 bis zu etwa 9/10, vorzugsweise von etwa 1/4 bis zu etwa 3/4, liegt und/oder
**dass** das Anschlussteil (3), der Anschlussbereich (1a) und/oder der Anschlussbereich (53) derart zusammengeführt sind, so dass mittels einer einzigen Anode und/oder mittels einer einzigen Kathode eine Vielzahl von Funktionselementen (60) versorgt werden kann und/oder
**dass** eine Vielzahl von Funktionselementen (60) an das Anschlussteil (3), den Anschlussbereich (1a) und/oder den Anschlussbereich (53) anschließbar sind, so dass mittels einer einzigen Anode und/oder mittels einer einzigen Kathode eine Vielzahl von Funktionselementen (60) versorgt werden kann

9. Matrix umfassend eine Vielzahl von Gehäusen (100) nach einem der vorstehenden Ansprüche

10. Matrix nach vorstehendem Anspruch **dadurch gekennzeichnet,**
**dass** die Anschlussteile (3), die Anschlussbereiche (1a) und/oder die Anschlussbereiche (53) der einzelnen Gehäuse (100) derart zusammengeführt sind, dass mittels einer einzigen Anode und/oder mittels einer einzigen Kathode eine Vielzahl von Gehäusen (100) versorgt werden kann und/oder
**dass** das Anschlussteil (3), der Anschlussbereich (1a) und/oder der Anschlussbereich (53) eines einzelnen Gehäuses (100) derart zusammengeführt sind, dass mittels einer einzigen Anode und/oder mittels einer einzigen Kathode eine Vielzahl von Funktionselementen in einem Gehäuse (100) versorgt werden kann oder
**dass** das Anschlussteil (3), der Anschlussbereich (1a) und/oder der Anschlussbereich (53) eines einzelnen Gehäuses (100) derart zusammengeführt sind, dass mittels einer einzigen Anode und/oder mittels einer einzigen Kathode eine Vielzahl von Funktionselementen in einem Gehäuse (100) versorgt werden kann und zumindest zwei Anschlussteile (3) pro Gehäuse (100) vorgesehen sind, um mehrere Funktionselemente (60) in einem Gehäuse (100) zu versorgen.

11. Opto-elektronisches Bauteil, umfassend ein Gehäuse (100) nach einem der vorstehenden Ansprüche und wenigstens ein strahlungsemittierendes und/oder strahlungsempfangendes opto-elektronisches Funktionselement (60), insbesondere eine LED (60), welches in dem Gehäuse (100) angeordnet ist.

12. Beleuchtungseinrichtung, welche wenigstens ein Gehäuse (100) nach einem der vorstehenden Ansprüche oder wenigstens ein opto-elektronisches Bauteil nach vorstehendem Anspruch beinhaltet.

13. Verfahren zur Herstellung eines opto-elektronischen Funktionselementgehäuses (100) nach einem der vorstehenden Ansprüche, umfassend
- Bereitstellen wenigstens eines Basisteils (1), dessen Oberseite (1a) zumindest abschnittsweise einen Montagebereich (12) für zumindest ein opto-elektronisches Funktionselement (60) definiert, so dass das Basisteil (1) einen Kühlkörper für das opto-elektronische Funktionselement (60) bildet,
- Bereitstellen wenigstens eines Kopfteils (5), das sich zumindest abschnittsweise über den Umfang des Montagebereichs (12) erstreckt und über dem Montagebereich (12) einen Durchgangsbereich (52,61) für die von dem opto-elektronischen Funktionselement (60) emittierte und/oder zu empfangende Strahlung bildet,
- wobei das Basisteil (1) in einer Matrix (10) mit einer Vielzahl an Basisteilen (1) und/oder das Kopfteil (5) in einer Matrix (50) mit einer Vielzahl an Kopfteilen (5) bereitgestellt wird bzw. werden,
- Bereitstellen wenigstens einer ersten Glasschicht (2) zwischen der Oberseite (1a) des Basisteils (1) und der Unterseite (5b) des Kopfteils (5) und
- Zusammenfügen des Basisteils (1), der ersten Glasschicht (2) und des Kopfteils (5) und
- Erwärmen der ersten Glasschicht (2) insoweit, dass das Glas eine Viskosität erreicht, bei der das Glas anhaftet und das Basisteil (1) und das Kopfteil (5) zumindest mittels der ersten Glasschicht (2) einen Verbund bilden, so dass eine Vielzahl an Gehäusen (100) gleichzeitig hergestellt werden,
wobei die Gehäuse (100) über das Basisteil (1) und/oder das Kopfteil (5) mittels Verbindungsstege (11, 51) an der Matrix (10) mit der Vielzahl an Basisteilen (1) und/oder an der Matrix (50) mit der Vielzahl an Kopfteilen (5) befestigt sind,
wobei zumindest die Oberseite (1a) des Basisteils (1) und/oder zumindest die Unterseite (5b) des Kopfteils (5) durch Kupfer bereitgestellt ist bzw. sind und
die Oberseite (1a) des Basisteils (1) und/oder die Unterseite (5b) des Kopfteils (5) derart voroxidiert ist bzw. sind, so dass eine Oxidschicht mit einem Flächengewicht von 0,067 mg/cm² bis 0,13 mg/cm², ausgebildet ist.

14. Verfahren nach vorstehendem Anspruch **dadurch gekennzeichnet**
**dass** wenigstens ein Anschlussteil (3) bereitgestellt wird, welches zwischen der Unterseite (5b) des Kopfteils (5) und der Oberseite (1a) des Basisteils (1) angeordnet wird und/oder
**dass** wenigstens eine zweite Glasschicht (4) zwischen der Oberseite (1a) des Basisteils (1) und der Unterseite (5b) des Kopfteils (5) angeordnet wird, welche durch das Erwärmen mit dem Verbund verbunden wird oder
**dass** wenigstens eine zweite Glasschicht (4) zwischen der Oberseite (1a) des Basisteils (1) und der Unterseite (5b) des Kopfteils (5) angeordnet wird, welche durch das Erwärmen mit dem Verbund verbunden wird und das Anschlussteil (3) zwischen der ersten Glasschicht (2) und der zweiten Glasschicht (4) angeordnet wird.

15. Verfahren nach einem der beiden vorstehenden Ansprüche **dadurch gekennzeichnet, dass** die Gehäuse (100) vollständig oder teilweise von der jeweiligen Matrix (10, 30, 50) getrennt werden.

## Claims

1. A housing (100) for an optoelectronic functional element (60), in particular an LED (60), comprising
- an assembly comprising at least one base part (1) and one top part (5); and
- wherein a portion of the upper surface (1a) of the base part (1) defines a mounting area (12) for at least one optoelectronic functional element (60), so that the base part (1) forms a heat sink for the optoelectronic functional element (60); and
- wherein the top part (5) extends at least partially around the circumference of the mounting area (12) and defines a passage area (52, 61) above the mounting area (12) for radiation emitted and/or to be received by the optoelectronic functional element (60); wherein
- the top part (5) comprises a metal and the base part (1) comprises a metal; wherein the base part (1) and the top part (5) are joined at least by a first glass layer (2) that is disposed between the upper surface (1a) of the base part (1) and the lower surface (5b) of the top part (5), ch
aracterized in that
the upper surface (1a) of the base part (1) is pre-oxidized and/or the lower surface (5b) of the top part (5) is pre-oxidized;
wherein at least the upper surface (1 a) of the base part (1) and/or at least the lower surface (5b) of the top part (5) is/are provided by copper; and
the upper surface (1a) of the base part (1) and/or the lower surface (5b) of the top part (5) is/are pre-oxidized such that an oxide layer with a basis weight from 0.067 mg/cm² to 0.13 mg/cm² is formed.

2. The housing according to the preceding claim, **characterized in**
**that** the base part (1) is composed of at least two layers (103,104,105,106, 107,108, 109); or
**that** the base part (1) is composed of at least two layers (103, 104, 105, 106, 107, 108, 109) and the at least two layers (103, 104, 105, 106, 107, 108, 109) of the base part (1) are arranged one above the other and/or next to one another.

3. The housing according to any one of the preceding claims, **characterized in**
**that** the base part (1) is made of at least a first material (101) and a second material (102); or
**that** the base part (1) is made of at least a first material (101) and a second material (102) and the first material (101) has an increased thermal conductivity compared to the second material (102) and the second material (102) has a lower coefficient of thermal expansion compared to the first material (101).

4. The housing according to any one of the preceding claims, **characterized in**
**that** the layer (103, 106) of the base part (1) comprising the first material (101) is in thermal contact with the functional element (60); and/or
**that** the layer (103, 106) of the base part (1) comprising the second material (102) is arranged for adaptation of thermal expansion of the first material (101) to the first glass layer (2); and/or
**that** the base part (1) is patterned at least in sections thereof, in particular in its upper surface (1a); and/or
**that** the base part (1) is configured so that the first material (101) is embedded in the second material (102) or so that the second material (102) is embedded in the first material (101).

5. The housing according to any one of the preceding claims, **characterized in**
**that** the top part (5) has at least one connection area (53) for the functional element (60); or
**that** the top part (5) has at least one connection area (53) for the functional element (60), and the connection area (53) is in the form of a kind of pedestal (53) on an inner surface of the top part (5).

6. The housing according to any one of the preceding claims, **characterized in**
**that** the inner surface of the passage area (52, 61) has reflective properties at least in sections thereof; and/or
**that** the base part (1) includes at least one connection area (1a) for the functional element (60).

7. The housing according to any one of the preceding claims, **characterized in**
**that** at least one connection part (3) is arranged between the lower surface (5b) of the top part (5) and the upper surface (1a) of the base part (1); or
**that** at least one connection part (3) is arranged between the lower surface (5b) of the top part (5) and the upper surface (1a) of the base part (1) and the connection part (3) is bonded to the assembly by at least the first glass layer (2) and/or a second glass layer (4); and/or
**that** the connection part (3) is disposed between the first glass layer (2) and a second glass layer (4).

8. The housing according to any one of the preceding claims, **characterized in**
**that** the first glass layer (2) and/or the second glass layer (2) has/have a reduced height in the area (22) adjoining the connection part (3); and/or
**that** at least one spacer (90) is arranged between the base part (1) and the top part (5) and/or between the base part (1) and the connection part (3) and/or between the top part (5) and the connection part (3); and/or
**that** the ratio of the surface area of the first glass layer (2) or of the second glass layer (4) to the surface area of the housing (100) is a ratio from about 1/10 to about 9/10, preferably from about 174 to about 3/4; and/or
**that** the connection part (3), the connection area (1a) and/or the connection area (53) are brought together such that a multitude of functional elements (60) can be powered by a single anode and/or by a single cathode; and/or
**that** a multitude of functional elements (60) can be connected to the connection part (3), the connection area (1a), and/or the connection area (53) such that a multitude of functional elements (60) can be powered by a single anode and/or by a single cathode.

9. An array comprising a plurality of housings (100) according to any one of the preceding claims.

10. The array according to the preceding claim, **characterized in**
**that** the connection parts (3), the connection areas (1a) and/or the connection areas (53) of the individual housings (100) are brought together such that a multitude of housings (100) can be powered by a single anode and/or by a single cathode; and/or
**that** the connection part (3), the connection area (1a) and/or the connection area (53) of an individual housing (100) are brought together such that a plurality of functional elements in a housing (100) can be powered by a single anode and/or by a single cathode; or
**that** the connection part (3), the connection area (1a) and/or the connection area (53) of an individual housing (100) are brought together such that a plurality of functional elements in a housing (100) can be powered by a single anode and/or by a single cathode and at least two connection parts (3) are provided per housing (100) in order to power a plurality of functional elements (60) in one housing (100).

11. An optoelectronic component, comprising a housing (100) according to any one of the preceding claims and at least one radiation emitting and/or radiation receiving optoelectronic functional element (60), in particular an LED (60), which is arranged in the housing (100).

12. A lighting device, comprising at least one housing (100) according to anyone of the preceding claims or at least one optoelectronic component according to the preceding claim.

13. A method for producing an optoelectronic functional element housing (100) according to any one of the preceding claims, comprising
- providing at least one base part (1), with an upper surface (1a) thereof defining a mounting area (12) for at least one optoelectronic functional element (60), at least in sections thereof, so that the base part (1) forms a heat sink for the optoelectronic functional element (60);
- providing at least one top part (5) which extends at least partially around the circumference of the mounting area (12) and defines a passage area (52, 61) for the radiation emitted and/or to be received by the optoelectronic functional element (60) above the mounting area (12);
- wherein the base part (1) is provided in an array (10) comprising a multitude of base parts (1) and/or the top part (5) is provided in an array (50) comprising a multitude of top parts (5);
- providing at least a first glass layer (2) between the upper surface (1a) of the base part (1) and the lower surface (5b) of the top part (5), and
- joining the base part (1), the first glass layer (2) and the top part (5), and
- heating the first glass layer (2) until the glass reaches a viscosity at which the glass adheres and the base part (1) and the top part (5) form an assembly at least by virtue of the first glass layer (2), so that a multitude of housings (100) are produced simultaneously;
wherein the housings (100) are attached to the array (10) comprising the multitude of base parts (1) and/or to the array (50) comprising the multitude of top parts (5) through the base part (1) and/or through the top part (5) via connecting webs (11,51);
wherein at least the upper surface (1a) of the base part (1) and/or at least the lower surface (5b) of the top part (5) is/are provided by copper; and
the upper surface (1a) of the base part (1) and/or the lower surface (5b) of the top part (5) is/are pre-oxidized such that an oxide layer with a basis weight from 0.067 mg/cm² to 0.13 mg/cm² is formed.

14. The method according to the preceding claim, **characterized in**
**that** at least one connection part (3) is provided, which is disposed between the lower surface (5b) of the top part (5) and the upper surface (1a) of the base part (1); and/or
**that** at least a second glass layer (4) is disposed between the upper surface (1a) of the base part (1) and the lower surface (5b) of the top part (5), which is bonded to the assembly by said heating; or
**that** at least a second glass layer (4) is disposed between the upper surface (1a) of the base part (1) and the lower surface (5b) of the top part (5), which is bonded to the assembly by said heating and the connection part (3) is disposed between the first glass layer (2) and the second glass layer (4).

15. The method according to any one of the two preceding claims, **characterized in that**
the housings (100) are completely or partially separated from the respective array (10, 30, 50).

## Revendications

1. Boîtier (100) pour un élément fonctionnel (60) opto-électronique, en particulier une DEL (60), comprenant
- un composite composé au moins d'une partie de base (1) et d'une partie de tête (5), et
- une section du côté supérieur (la) de la partie de base (1) définit une zone de montage (12) pour au moins un élément fonctionnel (60) opto-électronique de sorte que la partie de base (1) forme un corps de refroidissement pour l'élément fonctionnel (60) opto-électronique et
- la partie de tête (5) s'étend au moins par endroits sur la périphérie de la zone de montage (12) et forme au-dessus de la zone de montage (12) une zone de passage (52, 61) pour le rayonnement émis et/ou à recevoir par l'élément fonctionnel (60) opto-électronique, dans lequel
- la partie de tête (5) comprend un métal et la partie de base (1) comprend un métal,
dans lequel la partie de base (1) et la partie de tête (5) sont reliées au moins au moyen d'une première couche de verre (2), laquelle est disposée entre le côté supérieur (1a) de la partie de base (1) et le côté inférieur (5b) de la partie de tête (5), **caractérisé en ce**
**que** le côté supérieur (1a) de la partie de base (1) est oxydé au préalable et/ou le côté inférieur (5b) de la partie de tête (5) est oxydé au préalable,
dans lequel au moins le côté supérieur (1a) de la partie de base (1) et/ou au moins le côté inférieur (5b) de la partie de tête (5) est ou sont fourni(s) par du cuivre et le côté supérieur (1a) de la partie de base (1) et/ou le côté inférieur (5b) de la partie de tête (5) est ou sont oxydé(s) au préalable de telle manière qu'une couche
d'oxyde est réalisée avec un poids surfacique de 0,067 mg/cm² à 0,13 mg/cm².

2. Boîtier selon la revendication précédente, **caractérisé en ce**
**que** la partie de base (1) est élaborée à partir d'au moins deux couches (103, 104, 105, 106, 107, 108, 109) ou
**que** la partie de base (1) est élaborée à partir d'au moins deux couches (103, 104, 105, 106, 107, 108, 109) et les au moins deux couches (103, 104, 105, 106, 107, 108, 109) de la partie de base (1) sont disposées les unes par-dessus les autres et/ou les unes à côté des autres.

3. Boîtier selon l'une quelconque des revendications précédentes, **caractérisé en ce**
**que** la partie de base (1) est élaborée à partir d'au moins un premier matériau (101) et un deuxième matériau (102), ou
**que** la partie de base (1) est élaborée à partir d'au moins un premier matériau (101) et un deuxième matériau (102) et le premier matériau (101) possède par rapport au deuxième matériau (102) une conductivité thermique élevée et le deuxième matériau (102) possède par rapport au premier matériau (101) un coefficient de dilatation thermique plus bas.

4. Boîtier selon l'une quelconque des revendications précédentes, **caractérisé en ce**
**que** la couche (103, 106) de la partie de base (1), qui comprend le premier matériau (101), est en contact thermique avec l'élément fonctionnel (60), et/ou que la couche (103, 106) de la partie de base (1), qui comprend le deuxième matériau (102), est disposée au niveau de la première couche de verre (2) aux fins de l'adaptation d'une dilatation thermique du premier matériau (101), et/ou
**que** la partie de base (1) est structurée au moins par endroits, en particulier au niveau de son côté supérieur (1a), et/ou
**que** la partie de base (1) est élaborée de telle manière que le premier matériau (101) est incorporé dans le deuxième matériau (102) ou le deuxième matériau (102) est incorporé dans le premier matériau (101).

5. Boîtier selon l'une quelconque des revendications précédentes, **caractérisé en ce**
**que** la partie de tête (5) présente au moins une zone de raccordement (53) pour l'élément fonctionnel (60), ou que la partie de tête (5) présente au moins une zone de raccordement (53) pour l'élément fonctionnel (60), et la zone de raccordement (53) est réalisée au niveau d'un côté intérieur de la partie de tête (5) en tant qu'un type de socle (53).

6. Boîtier selon l'une quelconque des revendications précédentes, **caractérisé en ce**
**que** le côté intérieur de la zone de passage (52, 61) a des propriétés réfléchissantes au moins par endroits, et/ou que la partie de base (1) possède au moins une zone de raccordement (1a) pour l'élément fonctionnel (60).

7. Boîtier selon l'une quelconque des revendications précédentes, **caractérisé en ce**
**qu'**au moins une partie de raccordement (3) est disposée entre le côté inférieur (5b) de la partie de tête (5) et le côté supérieur (1a) de la partie de base (1), ou
**qu'**au moins une partie de raccordement (3) est disposée entre le côté inférieur (5b) de la partie de tête (5) et le côté supérieur (1a) de la partie de base (1) et la partie de raccordement (3) est reliée au composite au moins au moyen de la première couche de verre (2) et/ou d'une deuxième couche de verre (4), et/ou
**que** la partie de raccordement (3) est disposée entre la première couche de verre (2) et une deuxième couche de verre (4).

8. Boîtier selon l'une quelconque des revendications précédentes, **caractérisé en ce**
**que** la première couche de verre (2) et/ou la deuxième couche de verre (2), est ou sont réduite (s) dans leur hauteur dans la zone (22), qui repose au niveau de la partie de raccordement (3), et/ou
**qu'**au moins un écarteur (90) est disposé entre la partie de base (1) et la partie de tête (5) et/ou entre la partie de base (1) et la partie de raccordement (3) et/ou entre la partie de tête (5) et la partie de raccordement (3), et/ou
**que** le rapport entre la surface de la première couche de verre (2) ou de la deuxième couche de verre (4) et la surface du boîtier (100) se situe dans un rapport d'environ 1/10 à environ 9/10, de préférence d'environ 1/4 à environ 3/4, et/ou
**que** la partie de raccordement (3), la zone de raccordement (1a) et/ou la zone de raccordement (53) sont regroupées de telle manière qu'une pluralité d'éléments fonctionnels (60) peut être alimentée au moyen d'une unique anode et/ou au moyen d'une unique cathode, et/ou
**qu'**une pluralité d'éléments fonctionnels (60) peuvent être raccordés à la partie de raccordement (3), à la zone de raccordement (1a) et/ou à la zone de raccordement (53) de sorte qu'une pluralité d'éléments fonctionnels (60) peut être alimentée au moyen d'une unique anode et/ou au moyen d'une unique cathode.

9. Matrice comprenant une pluralité de boîtiers (100) selon l'une quelconque des revendications précédentes.

10. Matrice selon la revendication précédente, **caractérisée en ce**
**que** les parties de raccordement (3), les zones de raccordement (1a) et/ou les zones de raccordement (53) des divers boîtiers (100) sont regroupées de telle manière qu'une pluralité de boîtiers (100) peut être alimentée au moyen d'une unique anode et/ou au moyen d'une unique cathode, et/ou
**que** la partie de raccordement (3), la zone de raccordement (1a) et/ou la zone de raccordement (53) d'un boîtier (100) individuel sont regroupées de telle manière qu'une pluralité d'éléments fonctionnels dans un boîtier (100) peut être alimentée au moyen d'une unique anode et/ou au moyen d'une unique cathode, ou
**que** la partie de raccordement (3), la zone de raccordement (1a) et/ou la zone de raccordement (53) d'un boîtier (100) individuel sont regroupées de telle manière qu'une pluralité d'éléments fonctionnels dans un boîtier (100) peut être alimentée au moyen d'une unique anode et/ou au moyen d'une unique cathode et au moins deux parties de raccordement (3) sont prévues par boîtier (100) pour alimenter plusieurs éléments fonctionnels (60) dans un boîtier (100).

11. Composant opto-électronique, comprenant un boîtier (100) selon l'une quelconque des revendications précédentes et au moins un élément fonctionnel (60) opto-électronique d'émission de rayonnement et/ou de réception de rayonnement, en particulier une DEL (60), lequel est disposé dans le boîtier (100).

12. Système d'éclairage, lequel contient au moins un boîtier (100) selon l'une quelconque des revendications précédentes ou au moins un composant opto-électronique selon la revendication précédente.

13. Procédé de fabrication d'un boîtier d'élément fonctionnel (100) opto-électronique selon l'une quelconque des revendications précédentes, comprenant
- la fourniture d'au moins une partie de base (1), dont le côté supérieur (1a) définit au moins par endroits une zone de montage (12) pour au moins un élément fonctionnel (60) opto-électronique de sorte que la partie de base (1) forme un corps de refroidissement pour l'élément fonctionnel (60) opto-électronique,
- la fourniture d'au moins une partie de tête (5), qui s'étend au moins par endroits sur la périphérie de la zone de montage (12) et forme par-dessus la zone de montage (12) une zone de passage (52, 61) pour le rayonnement émis et/ou à recevoir par l'élément fonctionnel (60) opto-électronique,
dans lequel la partie de base (1) est fournie dans une matrice (10) avec une pluralité de parties de base (1) et/ou la partie de tête (5) est fournie dans une matrice (50) avec une pluralité de parties de tête (5),
- la fourniture d'au moins une première couche de verre (2) entre le côté supérieur (1a) de la partie de base (1) et le côté inférieur (5b) de la partie de tête (5), et
- le regroupement de la partie de base (1), de la première couche de verre (2) et de la partie de tête (5), et
- le réchauffage de la première couche de verre (2) jusqu'à ce que le verre atteigne une viscosité, à laquelle le verre adhère et la partie de base (1) et la partie de tête (5) forment au moins au moyen de la première couche de verre (2) un composite, de sorte qu'une pluralité de boîtiers (100) sont fabriqués dans le même temps,
dans lequel les boîtiers (100) sont fixés par l'intermédiaire de la partie de base (1) et/ou de la partie de tête (5) au moyen d'entretoises de liaison (11, 51) au niveau de la matrice (10) avec la pluralité de parties de base (1) et/ou au niveau de la matrice (50) avec la pluralité de parties de tête (5),
dans lequel au moins le côté supérieur (1a) de la partie de base (1) et/ou au moins le côté inférieur (5b) de la partie de tête (5) est ou sont fourni(s) par du cuivre, et le côté supérieur (1a) de la partie de base (1) et/ou le côté inférieur (5b) de la partie de tête (5) est ou sont oxydé(s) au préalable de telle manière qu'une couche d'oxyde est réalisée avec un poids surfacique de 0,067 mg/cm² à 0,13 g/cm².

14. Procédé selon la revendication précédente, **caractérisé en ce**
**qu'**au moins une partie de raccordement (3) est fournie, laquelle est disposée entre le côté inférieur (5b) de la partie de tête (5) et le côté supérieur (1a) de la partie de base (1), et/ou
**qu'**au moins une deuxième couche de verre (4) est disposée entre le côté supérieur (1a) de la partie de base (1) et le côté inférieur (5b) de la partie de tête (5), laquelle est reliée au composite par le réchauffage, ou
**qu'**au moins une deuxième couche de verre (4) est disposée entre le côté supérieur (1a) de la partie de base (1) et le côté inférieur (5b) de la partie de tête (5), laquelle est reliée au composite par le réchauffage, et la partie de raccordement (3) est disposée entre la première couche de verre (2) et la deuxième couche de verre (4).

15. Procédé selon l'une quelconque des deux revendications précédentes, **caractérisé en ce**
**que** les boîtiers (100) sont séparés en totalité ou en partie de la matrice (10, 30, 50) respective.
